# EUROPÄISCHE PATENTANMELDUNG

(11) **EP 3 495 886 A1**
(43) Veröffentlichungstag der Anmeldung: **12.06.2019**
(21) Anmeldenummer: 17205629.3
(22) Anmeldetag: 06.12.2017
(51) Int. Cl.: G03F 7/027

(54) **KLEBSTOFFFREIER PHOTOPOLYMERSCHICHTAUFBAU**

(71) Anmelder: Covestro Deutschland AG, 51373 Leverkusen (DE)
(72) Erfinder: Die Erfindernennung liegt noch nicht vor
(74) Vertreter: Levpat

(57) **Zusammenfassung**

Die Erfindung betrifft ein Verfahren zur Herstellung eines klebstofffrei-verbundenen Schichtaufbaus, einen Schichtaufbau umfassend eine belichtete Photopolymerschicht B und eine Substratschicht C aus (Co)Polycarbonat, ein versiegeltes optisches Medium enthaltend denn Schichtaufbau und eine optische Anzeige und ein Sicherheitsdokument umfassend das versiegelte optische Medium.

## Beschreibung

Die Erfindung betrifft ein Verfahren zur Herstellung eines klebstofffrei-verbundenen Schichtaufbaus, einen Schichtaufbau umfassend eine belichtete Photopolymerschicht B und eine Substratschicht C aus (Co)Polycarbonat, ein versiegeltes optisches Medium enthaltend denn Schichtaufbau und eine optische Anzeige und ein Sicherheitsdokument umfassend das versiegeltes optisches Medium.

Photopolymerschichten zur Herstellung holographischer Medien sind grundsätzlich aus der WO 2011/054797 und der WO 2011/067057 bekannt. Vorteile dieser holografischen Medien ist deren hohe diffraktive Lichtbeugungseffizienz und dass keine Nachprozessierungsschritte nach der holografischen Belichtung wie z.B. chemische oder thermische Entwicklungsschritte nötig sind.

In der Patentanmeldung WO2013/102603 A1 wird ein Schichtverbund aus einem Photopolymerfilm und einer Klebstoffschicht offenbart. Bei dem Aufbringen von Klebstoffschichten auf eine Photopolymerschicht besteht immer die Gefahr einer Farbveränderung des Hologramms in der Photopolymerschicht. Weiterhin müssen solche Verklebungstechniken auch Schichtaufbauten erlauben, die bei erhöhten Temperaturen eine Stabilität des Hologramms in der Photopolymerschicht sicherstellen.

In der Patentanmeldung WO2017/081078 A1 wird ein Verfahren zur Herstellung eines Schichtaufbaus beschrieben, bei dem zunächst eine Versiegelungsschicht auf eine Photopolymerschicht aufgebracht wird und anschließend mit Hilfe von aktinischer Strahlung gehärtet wird. Mit diesem Verfahren können nur belichtete Photopolymerschichten versiegelt werden, da die zur Härtung der Schutzschicht verwendete aktinische Strahlung eine unbelichtete Photopolymerschicht inaktiviert.

In der WO 2014/114654 A1 und DE 10 2013 200 980 A1 wird ein Verfahren zur nachträglichen holographischen Beschriftung offenbart. Der in diesem Verfahren eingesetzten Verbundkörper besteht aus mehreren Polycarbonatschichten, in welche eine unbelichtete Photopolymerschicht integiert ist. Die Integration der Photopolymerschicht wird bei Temperaturen im Bereich von 120 °C bis 220°C durchgeführt, vorzugsweise durch Lamination. Nachteilig ist, dass es bei derart hohen Temperaturen zur Schädigung der Photopolymerschicht und der Substratschichten aus Polycarbonat kommen kann.

Die Aufgabe der vorliegenden Erfindung bestand somit darin, ein Versiegelungsverfahren für belichete und unbelichtete Photopolymerfilme bereit zustellen, das eine stabilen Verbund der zwischen der Photopolymerschicht und der Schutzschicht erzeugt, ohne dabei die Photopolymerschicht oder Schutzschicht zu schädigen und / oder deren Eigenschaften zu beeinträchtigen. Desweiteren sollen für versiegelte Photopolymerfilme, die nach dem erfindungsgemäßen Verfahren hergestellt wurden, keine Nachprozessierungsschritte nach der holografischen Belichtung mehr benötigen werden.

Die Aufgabe wurde gelöst durch ein Verfahren zur Herstellung eines zumindest teilweise verbundenen Schichtaufbaus umfassend eine Photopolymerschicht B, enthaltend ein Hologramm, und eine Substratschicht C aus (Co)Polycarbonat, dadurch gekennzeichnet, dass das Verfahren die folgenden Schritte umfasst:
a) Direktes Inkontakbringen einer unbelichteten Photopolymerschicht B oder einer teilbelichteten Photopolymerschicht B, enthaltend ein Hologramm, mit der Substratschicht C, sodass ein Schichtverbund B-C entsteht,
b) Erwärmen des Schichtverbundes B-C auf eine Temperatur von 70° C bis 110° C,
c) Ggf. Einbelichten eines Hologramms in die unbelichtete Photopolymerschicht B, enthaltend Matrixpolymere, Schreibmonomere, Photoinitiatoren, gegebenenfalls mindestens eine nicht photopolymerisierbare Komponente und gegebenenfalls Katalysatoren, Radikalstabilisatoren, Lösungsmittel, Additive sowie andere Hilfs- und/oder Zusatzstoffe,
d) Beaufschlagen des teilbelichteten Schichtverbunds B-C, enthaltend ein Hologramm, mit aktinischer Strahlung, vorzugsweise enthaltend UV-Strahlung,
wobei Schritt d) immer als letzter Schritt durchgeführt wird. Die Photopolymerschicht B wird in dem erfindungsgemäßen Verfahren klebstofffrei mit der Substratschicht C verbunden.

Der Vorteil des erfindungsgemäßen Verfahrens besteht darin, dass es auf einfache Art die Versiegelung einer teilbelichteten oder unbelichteten Photopolymerschicht ermöglicht, das keine aufwändigen Maschinen oder besonders geschultes Personal erfordert und wobei die Komponenten B und C so aufeinander abgestimmt sind, dass sie einerseits eine gute Haftung ermöglichen und gleichzeitig einer Frequenzstabilität/Gitterstabilität des Holograms und einen Schutz vor chemischer, physikalischer und mechanischer Beanspruchung gewährleisten. Zusätzlich wird durch die klebstofffreie Verbindung der Substratschicht C mit der Photopolymerschicht B eine hohe Kompatibiltät erreicht sowie eine generelle verbesserte Handhabbarkeit der belichteten oder unbelichteten Photopolymerschicht, so z. B. ein Schutz gegen Verstauben durch Unterbindung von Restklebrigkeit oder ein Schutz gegen chemische und physikalische Einflüsse.

Die nach dem erfindungsgemäßen Verfahren hergestellte Schichtaufbauten weisen eine hohe Haftkraft zwischen der Photopolymerschicht B und der Substratschicht C auf, sodass der Schichtverbund gut weiterverarbeitet werden kann, z. B. in einem Spritzgussartikel, einem weiteren Laminationsschritt unterworfen werden kann oder auf eine Gießlinse aufgebracht werden kann. Auch ist es möglich den erhaltenen Schichtaufbau sowohl auf der Substratschicht A und der Substratschicht C durch einen weiteren Laminations- oder Verklebungsschritt ohne Einfluss auf das Hologramm zu verarbeiten. Verklebungschritte mit Flüssiglacken, die üblicherweise Lösemittel oder Reaktivverdünner enthalten können so nun auch verwendet werden ohne dass diese in die Photopolymerschicht B eindringen können und damit das Hologramm verändern würden.

In einer Ausführungsform des erfindungsgemäßen Verfahrens werden die Verfahrensschritte a)-d) in der Reihenfolge a), b), c) und d) oder in der Reihenfolge a), c), b) und d) oder in der Reihenfolge c), a), b) und d) durchgeführt werden, bevorzugt in der Reihenfolge c), a), b) und d) durchgeführt.

In einer Ausführungsform des erfindungsgemäßen Verfahrens, umfasst das Verfahren die folgenden Schritte:
a) Direktes Inkontaktbringen einer unbelichteten Photopolymerschicht B auf die Substratschicht C, sodass ein Schichtverbund B-C entsteht,
b) Erwärmen des Schichtverbunds B-C aus Schritt a) auf eine Temperatur von 70° C bis 110° C,
c) Einbelichten eines Hologramms, vorzugsweise eines Volumenhologramms, in die unbelichtete Photopolymerschicht B des Schichtverbundes B-C aus Schritt b), wobei die Photopolymerschicht B Matrixpolymere, Schreibmonomere, Photoinitiatoren, gegebenenfalls mindestens eine nicht photopolymerisierbare Komponente und gegebenenfalls Katalysatoren, Radikalstabilisatoren, Lösungsmittel, Additive sowie andere Hilfs- und/oder Zusatzstoffe enthält,
d) Beaufschlagen des Schichtverbundes B-C aus Schritt c) mit aktinischer Strahlung, vorzugsweise enthaltend UV-Strahlung,
wobei die Schritte in der angegebenen Reihenfolge durchlaufen werden.

In einer Ausführungsform des erfindungsgemäßen Verfahrens, umfasst das Verfahren die folgenden Schritte:
a) Direktes Inkontaktbringen einer unbelichteten Photopolymerschicht B auf die Substratschicht C, sodass ein Schichtverbund B-C entsteht,
b) Einbelichten eines Hologramms, vorzugsweise eines Volumenhologramms, in die unbelichtete Photopolymerschicht B des Schichtverbundes B-C aus Schritt a), wobei die Photopolymerschicht B Matrixpolymere, Schreibmonomere, Photoinitiatoren, gegebenenfalls mindestens eine nicht photopolymerisierbare Komponente und gegebenenfalls Katalysatoren, Radikalstabilisatoren, Lösungsmittel, Additive sowie andere Hilfs- und/oder Zusatzstoffe enthält,
c) Erwärmen des Schichtverbunds B-C aus Schritt b) auf eine Temperatur von 70° C bis 110° C,
d) Beaufschlagen des Schichtverbundes B-C aus Schritt c) mit aktinischer Strahlung, vorzugsweise enthaltend UV-Strahlung,
wobei die Schritte in der angegebenen Reihenfolge durchlaufen werden.

In einer Ausführungsform des erfindungsgemäßen Verfahrens, umfasst das Verfahren die folgenden Schritte:
a) Einbelichten eines Hologramms, vorzugsweise eines Volumenhologramms, in die unbelichtete Photopolymerschicht B, wobei die Photopolymerschicht B Matrixpolymere, Schreibmonomere, Photoinitiatoren, gegebenenfalls mindestens eine nicht photopolymerisierbare Komponente und gegebenenfalls Katalysatoren, Radikalstabilisatoren, Lösungsmittel, Additive sowie andere Hilfs- und/oder Zusatzstoffe enthält,
b) Direktes Inkontaktbringen der Photopolymerschicht B, enthaltend ein Hologramm, aus Schritt a) mit der Substratschicht C, sodass ein Schichtverbund B-C entsteht,
c) Erwärmen des Schichtverbunds B-C aus Schritt b) auf eine Temperatur von 70° C bis 110° C,
d) Beaufschlagen des Schichtverbundes B-C aus Schritt c) mit aktinischer Strahlung, vorzugsweise enthaltend UV-Strahlung,
wobei die Schritte in der angegebenen Reihenfolge durchlaufen werden.

In einer Ausführungsform des erfindungsgemäßen Verfahrens wird der Schichtverbund B-C in Schritt b) bzw. dem Erwärmungsschritt für 0,2 Sekundenbis 60 Minuten, vorzugsweise von 0,5 Sekunden bis 30 Minuten auf eine Temperatur von 70 °C bis 110 ° C erwärmt, vorzugsweise auf 75 °C bis 110 °C, bevorzugter auf 80° C bis 110° C, noch bevorzugter auf 90° C bis 110° C erwärmt wird.

In einer Ausführungsform des erfindungsgemäßen Verfahrens weist der Schichtverbund nach durchlaufen von Schritt b) bzw. dem Erwärmungsschritt eine Haftkraft in Anlehnung an ISO/IEC 10373 unter Verwendung einer Zugprüfmachinene nach DIN EN ISO 527-1 zwischen der Schicht B und C von mindestens 0,5 N/lOmm, vorzugsweise von mindestens 0,8 N/lOmm, bevorzugter von 0,9 N/lOmm, noch bevorzugter von 1,2 N/lOmm auf.

In einer anderen Ausführungsform des erfindungsgemäßen Verfahrens weist der Schichtverbund nach durchlaufen von Schritt b) bzw. dem Erwärmungsschritt eine Haftkraft in Anlehnung an ISO/IEC 10373 unter Verwendung einer Zugprüfmachinene nach DIN EN ISO 527-1 zwischen der Schicht B und C von mindestens 0,5 N/lOmm, vorzugsweise von mindestens 0,8 N/lOmm, bevorzugter von mindestens 0,9 N/lOmm, noch bevorzugter von mindestens 1,2 N/lOmm auf, wobei im Erwärungschritt für 30 Sekunden bei mindestens 70° C erwärmt wurde.

In einer Ausführungsform des erfindungsgemäßen Verfahrens beträgt die Temperatur in Schritt b) 75° C bis 110° C, vorzugsweise 80° C bis 110° C, noch bevorzugter 90° C bis 110° C.

In einer Ausführungsform des erfindungsgemäßen Verfahrens wird Schritt b) bzw. dem Erwärmungsschritt in einem beheizten Raum, vorzugsweise einem Ofen, oder einem Laminator durchgeführt.

In einer Ausführungsform des erfindungsgemäßen Verfahrens werden Schritt a) bzw. der Schritt des direkten Inkontaktbringes der Photopolymerschicht und der Substratschicht C und Schritt b) bzw. dem Erwärmungsschritt in einem gemeinsamen Schritt durchgeführt.

In einer Ausführungsform des erfindungsgemäßen Verfahrens liegt die Photopolymerschicht B auf einer Substratschicht A vor, wobei die Schichten A und B klebstofffrei miteinander verbunden sind, wobei die Substratschicht A vorzugsweise eine transparente thermoplastische Substratschicht oder Glas ist.

In einer Ausführungsform des erfindungsgemäßen Verfahrens liegt die Substratschicht C auf einer Substratschicht D vor und ist mit dieser zumindest teilweise verbunden, vorzugsweise klebstofffrei verbunden, wobei die Substratschicht D vorzugsweise aus einem transparenten thermoplastischen Material oder einem Materialverbund besteht.

In einer Ausführungsform des erfindungsgemäßen Verfahrens ist die Glasübergangstemperatur T_{g} der Substratschicht C höher, als die Temperatur in den Verfahrenschritten a)-d) zur Herstellung des erfindungsgemäßen Schichtverbundes B-C.

Mit aktinischer Strahlung ist elektromagneitsche Strahlung gemeint, die sich eine Wellenlänge im sichtbaren (400 nm bis 800 nm) spektralen Bereich aufweist sowie im UV-C, UV-B und/oder im UV-A Bereich liegt. Bevorzugt wird mit aktinischer Strahlung im spektralen Bereich des UV Bereich, bevorzugt im UV-A und/oder UV-B Bereich liegt. Ebenfalls ist es bevorzugt UV und sichtbaren Bereich zu kombinieren, wie es in Quecksilberdampflampen typischerweise erzeugt werden kann. Ebenfalls ist es möglich eine solche Mischung aus sichtbaren Licht mit weissen LEDs und UV-Licht mit UV-LEDs (z.B. 360-370 nm emitierende LEDs) zu erzeugen.

In einer Ausführungsform des erfindungsgemäßen Verfahrens ist die Substratschicht C eine aromatische Polycarbonatschicht, vorzugsweise eine aromatische Homopolycarbonatschicht.

Materialien oder Materialverbünde der Substratschicht A basieren auf Polycarbonat (PC), Polyethylenterephthalat (PET), amorphe Polyester, Polybutylenterephthalat, Polyethylen, Polypropylen, Celluloseacetat, Cellulosehydrat, Cellulosenitrat, Cycloolefinpolymere, Polystyrol, hydriertem Polystyrol, Polyepoxide, Polysulfon, thermoplastisches Polyurethan (TPU), Cellulosetriacetat (CTA), Polyamid (PA), Polymethylmethacrylat (PMMA), Polyvinylchlorid, Polyvinylacetat, Polyvinylbutyral oder Polydicyclopentadien oder deren Mischungen. Besonders bevorzugt basieren sie auf PC, PET, PA, PMMA und CTA. Materialverbünde können Folienlaminate oder Coextrudate sein. Bevorzugte Materialverbünde sind Duplex- und Triplexfolien aufgebaut nach einem der Schemata A/B, A/B/A oder A/B/C. Besonders bevorzugt sind PC/PMMA, PC/PA, PC/PET, PET/PC/PET und PC/TPU. Vorzugsweise ist Substratschicht A im spektralen Bereich von 400-800 nm transparent.

Die Photopolymerschicht B umfasst Matrixpolymere, Schreibmonomere und Photoinitiatoren. Als Matrixpolymere können amorphe Thermoplaste wie z.B. Polyacrylate, Polymethylmethacrylate oder Copolymere von Methylmethacrylat, Methacrylsäure oder andere Alkylacrylate und Alkylmethacrylate sowie Acrylsäure, wie z.B. Polybutylacrylat, weiterhin Polyvinylacetat und Polyvinylburyrat seine partiell hydrolysierten Derivate wie Polyvinylalkohole sowie Copolymerisate mit Ethylene und/oder weiteren (Meth)acrylaten, Gelatine, Celluloseester und Celluloseether wie Methylcellulose, Celluloseacetobutyrat, Silikone, wie z.B. Polydimethylsilicon, Polyurethane, Polybutadiene und Polyisoprene, sowie Polyethylenoxide, Epoxyharze, insbesondere aliphatische Epoxyharze, Polyamide, Polycarbonate sowie die in US 4994347A und darin zitierten Systeme verwendet werden.

Besonders bevorzugt ist aber, wenn die Matrixpolymere Polyurethane sind.

Besonders bevorzugt ist auch, wenn die Matrixpolymere vernetzt sind. Insbesondere bevorzugt ist dabei, wenn die Matrixpolymere dreidimensional vernetzt sind.

Epoxyharze können kationisch mit sich selbst vernetzt werden. Weiterhin können auch Säure/anhydride, Amine, Hydoxyalkylamide sowie Thiole als Vernetzer eingesetzt werden.

Silicone können sowohl als Einkomponentensysteme durch Kondensation bei Anwesenheit von Wasser (und ggf. unter Broenstedtsäurenkatalyse) oder als zweikomponentige Systeme durch Zugabe von Kieselsäureester oder zinnorganische Verbindungen vernetzt werden. Ebenso ist die Hydrosilylierungen in Vinyl-Silansystemen möglich.

Ungesättigte Verbindungen, wie z.B. Acryloyl funktionelle Polymere oder ungesättigte Ester können mit Aminen oder Thiolen vernetzt werden. Eine kationische Vinyletherpolymerisation ist auch möglich.

Insbesondere bevorzugt ist aber, wenn die Matrixpolymere vernetzt, bevorzugt dreidimensional vernetzt und ganz besonders bevorzugt dreidimensional vernetzte Polyurethane sind. Polyurethan-Matrixpolymere sind insbesondere durch Umsetzung wenigstens einer Polyisocyanat-Komponente a) mit wenigstens einer Isocyanat-reaktiven-Komponente b) erhältlich.

Die Polyisocyanat-Komponente a) umfasst wenigstens eine organische Verbindung mit wenigstens zwei NCO-Gruppen. Bei diesen organischen Verbindungen kann es sich insbesondere um monomere Di- und Triisocyanate, Polyisocyanate und / oder NCO-funktionelle Prepolymere handeln. Die Polyisocyanat-Komponente a) kann auch Mischungen monomerer Di- und Triisocyanate, Polyisocyanate und / oder NCO-funktioneller Prepolymere enthalten oder daraus bestehen.

Als monomere Di- und Triisocyanate können alle dem Fachmann an sich gut bekannten Verbindungen oder deren Mischungen eingesetzt werden. Diese Verbindungen können aromatische, araliphatische, aliphatische oder cycloaliphatische Strukturen aufweisen. In untergeordneten Mengen können die monomeren Di- und Triisocyanate auch Monoisocyanate, d.h. organische Verbindungen mit einer NCO-Gruppe umfassen.

Beispiele für geeignete monomere Di- und Triisocyanate sind 1,4-Butandiisocyanat, 1,5-Pentandiisocyanat, 1,6-Hexandiisocyanat (Hexamethylendiisocyanat, HDI), 2,2,4-Trimethylhexamethylendiisocyanat und / oder 2,4,4-Trimethylhexamethylendiisocyanat (TMDI), Isophorondiisocyanat (IPDI), 1,8-Diisocyanato-4-(isocyanatomethyl)-octan, Bis-(4,4'-isocyanatocyclohexyl)methan und / oder Bis-(2',4-isocyanatocyclohexyl)methan und / oder deren Mischungen beliebigen Isomerengehalts, 1,4-Cyclohexandiisocyanat, die isomeren Bis-(isocyanatomethyl)cyclohexane, 2,4- und / oder 2,6-Diisocyanato-1-methylcyclohexan (Hexahyd-ro-2,4- und / oder 2,6-toluylendiisocyanat, H₆-TDI), 1,4-Phenylendiisocyanat, 2,4- und / oder 2,6-Toluylendiisocyanat (TDI), 1,5-Naphthylendiisocyanat (NDI), 2,4'- und / oder 4,4'-Diphenylmethandiisocyanat (MDI), 1,3-Bis(isocyanatomethyl)benzol (XDI) und / oder das analoge 1,4-Isomere oder beliebige Mischungen der vorgenannten Verbindungen.

Geeignete Polyisocyanate sind Verbindungen mit Urethan-, Harnstoff-, Carbodiimid-, Acylharnstoff-, Amid-, Isocyanurat-, Allophanat-, Biuret-, Oxadiazintrion-, Uretdion- und/oder Iminooxadiazindionstrukturen, die aus den vorgenannten Di- oder Triisocyanaten erhältlich sind.

Besonders bevorzugt handelt es sich bei den Polyisocyanaten um oligomerisierte aliphatische und / oder cycloaliphatische Di- oder Triisocyanate, wobei insbesondere die oben stehenden aliphatischen und / oder cycloaliphatischen Di- oder Triisocyanate verwendet werden können.

Ganz besonders bevorzugt sind Polyisocyanate mit Isocyanurat-, Uretdion- und / oder Iminooxadiazindion-Strukturen sowie Biurete basierend auf HDI oder deren Mischungen.

Geeignete Prepolymere enthalten Urethan- und / oder Harnstoff-Gruppen sowie gegebenenfalls weitere durch Modifizierung von NCO-Gruppen entstandene Strukturen wie oben genannt. Derartige Prepolymere sind beispielsweise durch Umsetzung der oben genannten monomeren Di- und Triisocyanate und / oder Polyisocyanaten a1) mit isocyanatreaktiven Verbindungen b1) erhältlich.

Als isocyanatreaktive Verbindungen b1) können Alkohole, Amino oder Mercapto-Verbindungen, bevorzugt Alkohole, verwendet werden. Dabei kann es sich insbesondere um Polyole handeln. Ganz besonders bevorzugt können als isocyanatreaktive Verbindung b1) Polyester-, Polyether-, Polycarbonat-, Poly(meth)acrylat- und/oder Polyurethan-Polyole verwendet werden.

Als Polyesterpolyole sind beispielsweise lineare Polyesterdiole oder verzweigte Polyesterpolyole geeignet, die in bekannter Weise durch Umsetzung von aliphatischen, cycloaliphatischen oder aromatischen Di- bzw. Polycarbonsäuren bzw. ihren Anhydriden mit mehrwertigen Alkoholen einer OH-Funktionalität ≥ 2 erhalten werden können. Beispiele für geeignete Di- bzw. Polycarbonsäuren sind mehrwertige Carbonsäuren wie Bernstein-, Adipin-, Kork-, Sebacin-, Decandicarbon-, Phthal-, Terephthal-, Isophthal- Tetrahydrophthal- oder Trimellithsäure sowie Säureanhydride wie Phthal-, Trimellith- oder Bernsteinsäureanhydrid oder deren beliebige Gemische untereinander. Die Polyesterpolyole können auch auf natürlichen Rohstoffen wie Rizinusöl basieren. Es ist ebenfalls möglich, dass die Polyesterpolyole auf Homo- oder Mischpolymerisaten von Lactonen basieren, die bevorzugt durch Anlagerung von Lactonen bzw. Lactongemischen wie Butyrolacton, ε-Caprolacton und / oder Methyl-ε-caprolacton an hydroxyfunktionelle Verbindungen wie mehrwertige Alkohole einer OH-Funktionalität ≥ 2 beispielsweise der nachstehend genannten Art erhalten werden können.

Beispiele für geeignete Alkohole sind alle mehrwertigen Alkohole wie z.B. die C₂ - C₁₂-Diole, die isomeren Cyclohexandiole, Glycerin oder deren beliebige Gemische untereinander.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkohole einer OH-Funktionalität ≥ 2, bevorzugt Butandiol-1,4, Hexandiol-1,6 und / oder 3-Methylpentandiol. Auch Polyesterpolyole können zu Polycarbonatpolyolen umgearbeitet werden.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden. Besonders bevorzugt sind Propylenoxid-homopolymere sowie statistische oder Block-Copolymere, die Oxyethylen-, Oxypropylen- und / oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylen umfasst hierbei alle jeweiligen linearen und verzweigten C₃- und C₄-Isomere.

Daneben sind als Bestandteile der Polyol-Komponente b1) als polyfunktionelle, isocyanatreaktive Verbindungen auch niedermolekulare, d.h. mit Molekulargewichten ≤ 500 g/mol, kurzkettige, d.h. 2 bis 20 Kohlenstoffatome enthaltende aliphatische, araliphatische oder cycloaliphatische di-, tri- oder polyfunktionelle Alkohole geeignet.

Dies können beispielsweise in Ergänzung zu den oben genannten Verbindungen Neopentylglykol, 2-Ethyl-2-butylpropandiol, Trimethylpentandiol, stellungs-isomere Diethyloctandiole, Cyclohexandiol, 1,4-Cyclohexandimethanol, 1,6-Hexandiol, 1,2- und 1,4-Cyclohexandiol, hydriertes Bisphenol A, 2,2-Bis(4-hydroxy-cyclohexyl)-propan oder 2,2-Dimethyl-3-hydroxypropionsäure, 2,2-dimethyl-3-hydroxypropyl-ester sein. Beispiele geeigneter Triole sind Trimethylolethan, Trimethylolpropan oder Glycerin. Geeignete höherfunktionelle Alkohole sind Di-(trimethylolpropan), Pentaerythrit, Dipenta-erythrit oder Sorbit.

Besonders bevorzugt ist, wenn die Polyolkomponente ein difunktioneller Polyether-, Polyester oder ein Polyether-polyester-block-copolyester oder ein Polyether-Polyester-Blockcopolymer mit primären OH-Funktionen ist.

Es ist ebenfalls möglich, als isocyanatreaktive Verbindungen b1) Amine einzusetzen. Beispiele geeigneter Amine sind Ethylendiamin, Propylendiamin, Diaminocyclohexan, 4,4'-Dicylohexylmethandiamin, Isophorondiamin (IPDA), difunktionelle Polyamine wie z.B. die Jeffamine®, aminterminierte Polymere, insbesondere mit zahlenmittleren Molmassen ≤ 10000 g/Mol. Mischungen der vorgenannten Amine können ebenfalls verwendet werden.

Es ist ebenfalls möglich, als isocyanatreaktive Verbindungen b1) Aminoalkohole einzusetzen. Beispiele geeigneter Aminoalkohole sind die isomeren Aminoethanole, die isomere Aminopropanole die isomeren Aminobutanole und die isomeren Aminohexanole oder deren beliebige Mischungen.

Alle vorgenannten isocyanatreaktiven Verbindungen b1) können untereinander beliebig vermischt werden.

Bevorzugt ist auch, wenn die isocyanatreaktiven Verbindungen b1) eine zahlenmittlere Molmasse von ≥ 200 und ≤ 10000 g/Mol, weiter bevorzugt ≥ 500 und ≤ 8000 g/Mol und ganz besonders bevorzugt ≥ 800 und ≤ 5000 g/Mol aufweisen. Die OH-Funktionalität der Polyole beträgt bevorzugt 1.5 bis 6.0, besonders bevorzugt 1.8 bis 4.0.

Die Prepolymere der Polyisocyanat-Komponente a) können insbesondere einen Restgehalt an freiem monomeren Di- und Triisocyanaten < 1 Gew.-%, besonders bevorzugt < 0.5 Gew.-% und ganz besonders bevorzugt < 0.3 Gew.-% aufweisen.

Es ist gegebenenfalls auch möglich, dass die Polyisocyanat-Komponente a) vollständig oder anteilsmäßig organische Verbindung enthält, deren NCO-Gruppen ganz oder teilweise mit aus der Beschichtungstechnologie bekannten Blockierungsmitteln umgesetzt sind. Beispiel für Blockierungsmittel sind Alkohole, Lactame, Oxime, Malonester, Pyrazole sowie Amine, wie z.B. Butanonoxim, Diisopropylamin, Malonsäurediethylester, Acetessigester, 3,5-Dimethylpyrazol, ε-Caprolactam, oder deren Mischungen.

Besonders bevorzugt ist, wenn die Polyisocyanat-Komponente a) Verbindungen mit aliphatisch gebundenen NCO-Gruppen umfasst, wobei unter aliphatisch gebundenen NCO-Gruppen derartige Gruppen verstanden werden, die an ein primäres C-Atom gebunden sind. Die isocyanatreaktive Komponente b) umfasst bevorzugt wenigstens eine organische Verbindung, die im Mittel wenigstens 1.5 und bevorzugt 2 bis 3 isocyanatreaktive Gruppen aufweist. Im Rahmen der vorliegenden Erfindung werden als isocyanatreaktive Gruppen bevorzugt Hydroxy-, Amino- oder MercaptoGruppen angesehen.

Die isocyanatreaktive Komponente kann insbesondere Verbindungen umfassen, die im Zahlenmittel wenigstens 1.5 und bevorzugt 2 bis 3 isocyanatreaktive Gruppen aufweisen.

Geeignete polyfunktionelle, isocyanatreaktive Verbindungen der Komponente b) sind beispielsweise die oben beschriebenen Verbindungen b1).

Ganz besonders bevorzugt ist auch, wenn die Polyurethane auf Polyester-C4-Polyetherpolyolen basieren.

Photoinitiatoren der Komponente sind üblicherweise durch aktinische Strahlung aktivierbare Verbindungen, die eine Polymerisation der Schreibmonomere auslösen können. Bei den Photoinitiatoren kann zwischen unimolekularen (Typ I) und bimolekularen (Typ II) Initiatoren unterschieden werden. Des Weiteren werden sie je nach ihrer chemischen Natur in Photoinitiatoren für radikalische, anionische, kationische oder gemischte Art der Polymerisation unterschieden.

Typ I-Photoinitiatoren (Norrish-Typ-I) für die radikalische Photopolymerisation bilden beim Bestrahlen durch eine unimolekulare Bindungsspaltung freie Radikale. Beispiele für Typ I-Photoinitiatoren sind Triazine, Oxime, Benzoinether, Benzilketale, Bis-imidazole, Aroylphosphinoxide, Sulfonium- und Iodoniumsalze.

Typ II-Photoinitiatoren (Norrish-Typ-II) für die radikalische Polymerisation bestehen aus einem Farbstoff als Sensibilisator und einem Coinitiator und durchlaufen bei der Bestrahlung mit auf den Farbstoff angepasstem Licht eine bimolekulare Reaktion. Zunächst absorbiert der Farbstoff ein Photon und überträgt aus einem angeregten Zustand Energie auf den Coinitiator. Dieser setzt durch Elektronen- oder Protonentransfer oder direkte Wasserstoffabstraktion die polymerisationsauslösenden Radikale frei.

Im Sinne dieser Erfindung werden bevorzugt Typ II-Photoinitiatoren verwendet.

Solche Photoinitiatorsysteme sind prinzipiell in der EP 0 223 587 A beschriebenen und bestehen bevorzugt aus einer Mischung von einem oder mehreren Farbstoffen mit Ammoniumalkylarylborat(en).

Geeignete Farbstoffe, die zusammen mit einem Ammoniumalkylarylborat einen Typ II-Photoinitiator bilden, sind die in der WO 2012062655 beschriebenen kationischen Farbstoffe in Kombination mit den eben dort beschriebenen Anionen.

Unter kationischen Farbstoffen werden bevorzugt solche der folgenden Klassen verstanden: Acridin-Farbstoffe, Xanthen-Farbstoffe, Thioxanthen-Farbstoffe, Phenazin-Farbstoffe, Phenoxazin-Farbstoffe, Phenothiazin-Farbstoffe, Tri(het)arylmethan-Farbstoffe - insbesondere Diamino- und Triamino(het)arylmethan-Farbstoffe, Mono-, Di-, Tri- und Pentamethincyanin-Farbstoffe, Hemicyanin-Farbstoffe, extern kationische Merocyanin-Farbstoffe, extern kationische Neutrocyanin-Farbstoffe, Nullmethin-Farbstoffe - insbesondere Naphtholactam-Farbstoffe, Streptocyanin-Farbstoffe. Solche Farbstoffe sind beispielsweise in H. Berneth in Ullmann's Encyclopedia of Industrial Chemistry, Azine Dyes, Wiley-VCH Verlag, 2008, H. Berneth in Ullmann's Encyclopedia of Industrial Chemistry, Methine Dyes and Pigments, Wiley-VCH Verlag, 2008, T. Gessner, U. Mayer in Ullmann's Encyclopedia of Industrial Chemistry, Triarylmethane and Diarylmethane Dyes, Wiley-VCH Verlag, 2000 beschrieben.

Besonders bevorzugt sind Phenazin-Farbstoffe, Phenoxazin-Farbstoffe, Phenothiazin-Farbstoffe, Tri(het)arylmethan-Farbstoffe - insbesondere Diamino- und Triamino(het)arylmethan-Farbstoffe, Mono-, Di-, Tri- und Pentamethincyanin-Farbstoffe, Hemicyanin-Farbstoffe, Nullmethin-Farbstoffe - insbesondere Naphtholactam-Farbstoffe, Streptocyanin-Farbstoffe.

Beispiele für kationische Farbstoffe sind Astrazon Orange G, Basic Blue 3, Basic Orange 22, Basic Red 13, Basic Violett 7, Methylenblau, Neu Methylenblau, Azur A, 2,4-Diphenyl-6-(4-methoxyphenyl)pyrylium, Safranin O, Astraphloxin, Brilliant Grün, Kristallviolett, Ethylviolett und Thionin.

Bevorzugte Anionen sind insbesondere C₈- bis C₂₅-Alkansulfonat, vorzugsweise C₁₃- bis C₂₅-Alkansulfonat, C₃- bis C₁₈-Perfluoralkansulfonat, C₄- bis C₁₈-Perfluoralkansulfonat, das in der Alkylkette mindestens 3 Wasserstoffatome trägt, C₉- bis C₂₅-Alkanoat, C₉- bis C₂₅-Alkenoat, C₈- bis C₂₅-Alkylsulfat, vorzugsweise C₁₃- bis C₂₅-Alkylsulfat, C₈- bis C₂₅-Alkenylsulfat, vorzugsweise C₁₃- bis C₂₅-Alkenylsulfat, C₃- bis C₁₈-Perfluoralkylsulfat, C₄- bis C₁₈-Perfluoralkylsulfat, das in der Alkylkette mindestens 3 Wasserstoffatome trägt, Polyethersulfate basierend auf mindestens 4 Äquivalenten Ethylenoxid und/oder Äquivalenten 4 Propylenoxid, Bis-C₄- bis C₂₅-Alkyl-, C₅- bis C₇-Cycloalkyl-, C₃- bis C₈-Alkenyl- oder C₇- bis C₁₁-Aralkyl-sulfosuccinat, durch mindestens 8 Fluoratome substituiertes Bis-C₂- bis C₁₀-alkyl-sulfosuccinat, C₈- bis C₂₅-Alkyl-sulfoacetate, durch mindestens einen Rest der Gruppe Halogen, C₄- bis C₂₅-Alkyl, Perfluor-C₁- bis C₈-Alkyl und/oder C₁- bis C₁₂-Alkoxycarbonyl substituiertes Benzolsulfonat, ggf. durch Nitro, Cyano, Hydroxy, C₁-bis C₂₅-Alkyl, C₁- bis C₁₂-Alkoxy, Amino, C₁- bis C₁₂-Alkoxycarbonyl oder Chlor substituiertes Naphthalin- oder Biphenylsulfonat, ggf. durch Nitro, Cyano, Hydroxy, C₁- bis C₂₅-Alkyl, C₁- bis C₁₂-Alkoxy, C₁- bis C₁₂-Alkoxycarbonyl oder Chlor substituiertes Benzol-, Naphthalin- oder Biphenyldisulfonat, durch Dinitro, C₆- bis C₂₅-Alkyl, C₄- bis C₁₂-Alkoxycarbonyl, Benzoyl, Chlorbenzoyl oder Toluoyl substituiertes Benzoat, das Anion der Naphthalindicarbonsäure, Diphenyletherdisulfonat, sulfonierte oder sulfatierte, ggf. mindestens einfach ungesättigte C₈- bis C₂₅-Fettsäureester von aliphatischen C₁- bis C₈-Alkoholen oder Glycerin, Bis-(sulfo-C₂- bis C₆-alkyl)-C₃- bis C₁₂-alkandicarbonsäureester, Bis-(sulfo-C₂- bis C₆-alkyl)-itaconsäureester, (Sulfo-C₂- bis C₆-alkyl)-C₆- bis C₁₈-alkancarbonsäureester, (Sulfo-C₂- bis C₆-alkyl)-acryl- oder methacrylsäureester, ggf. durch bis zu 12 Halogenreste substituiertes Triscatecholphosphat, ein Anion der Gruppe Tetraphenylborat, Cyanotriphenylborat, Tetraphenoxyborat, C₄- bis C₁₂-Alkyl-triphenylborat, deren Phenyl- oder Phenoxy-Reste durch Halogen, C₁- bis C₄-Alkyl und/oder C₁- bis C₄-Alkoxy substituiert sein können, C₄- bis C₁₂-Alkyl-trinaphthylborat, Tetra-Ci- bis C₂₀-alkoxyborat, 7,8- oder 7,9-Dicarba-nido-undecaborat(1-) oder (2-), die gegebenenfalls an den B- und/oder C-Atomen durch eine oder zwei C₁- bis C₁₂-Alkyl- oder Phenyl-Gruppen substituiert sind, Dodecahydro-dicarbadodecaborat(2-) oder B-C₁- bis C₁₂-Alkyl-C-phenyl-dodecahydro-dicarbadodecaborat(1-) steht, wobei bei mehrwertigen Anionen wie Naphthalindisulfonat A⁻ für ein Äquivalent dieses Anions steht, und wobei die Alkan- und Alkylgruppen verzweigt sein können und/oder durch Halogen, Cyano, Methoxy, Ethoxy, Methoxycarbonyl oder Ethoxycarbonyl substituiert sein können.

Bevorzugt ist auch, wenn das Anion A⁻ des Farbstoffs einen AClogP im Bereich von 1 bis 30, besonders bevorzugt im Bereich von 1 bis 12 und insbesondere bevorzugt im Bereich von 1 bis 6,5 aufweist. Der AClogP wird nach J. Comput. Aid. Mol. Des. 2005, 19, 453; Virtual Computational Chemistry Laboratory, http://www.vcclab.org berechnet.

Geeignete Ammoniumalkylarylborate sind beispielsweise (Cunningham et al., RadTech'98 North America UV/EB Conference Proceedings, Chicago, Apr. 19-22, 1998): Tetrabutylammonium Triphenylhexylborat, Tetrabutylammonium Triphenylbutylborat, Tetrabutylammonium Trinapthylhexylborat, Tetrabutylammonium Tris(4-tert.butyl)-phenylbutylborat, Tetrabutylammonium Tris-(3-fluorphenyl)-hexylborat hexylborat ([191726-69-9], CGI 7460, Produkt der BASF SE, Basel, Schweiz), 1-Methyl-3-octylimidazolium Dipentyldiphenylborat und Tetrabutylammonium Tris-(3-chlor-4-methylphenyl)-hexylborat ([1147315-11-4], CGI 909, Produkt der BASF SE, Basel, Schweiz).

Es kann vorteilhaft sein, Gemische dieser Photoinitiatoren einzusetzen. Je nach verwendeter Strahlungsquelle muss Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Technology, London, S. 61 - 328 beschrieben.

Ganz besonders bevorzugt ist, wenn der Photoinitiator eine Kombination von Farbstoffen, deren Absorptionsspektren zumindest teilweise den Spektralbereich von 400 bis 800 nm abdecken, mit wenigstens einem auf die Farbstoffe abgestimmten Coinitiator umfasst.

Bevorzugt ist auch, wenn wenigstens ein für eine Laserlichtfarbe ausgewählt aus blau, grün und rot geeigneter Photoinitiator in der Photopolymerschicht B enthalten ist.

Weiter bevorzugt ist auch, wenn die Photopolymerschicht B für wenigstens zwei Laserlichtfarben ausgewählt aus blau, grün und rot je einen geeigneten Photoinitiator enthält.

Ganz besonders bevorzugt ist schließlich, wenn die Photopolymerschicht B für jede der Laserlichtfarben blau, grün und rot jeweils einen geeigneten Photoinitiator enthält.

Besonders hohe Brechungsindexkontraste können erzielt werden, wenn die Photopolymerschicht B ein acrylat- oder methacrylatfunktionelles Schreibmonomer umfasst. Besonders bevorzugt sind dabei monofunktionelle Schreibmonomere und insbesondere diejenigen monofunktionellen Urethan(meth)acrylate, die in der US 2010/0036013 A1 beschrieben sind.

Geeignete Acrylat-Schreibmonomere sind insbesondere Verbindungen der allgemeinen Formel (I) 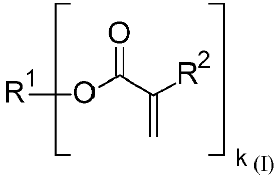 bei denen k≥1 und k≤4 ist und R¹ ein linearer, verzweigter, cyclischer oder heterocyclischer unsubstituierter oder gegebenenfalls auch mit Heteroatomen substituierter organischer Rest und/oder R² Wasserstoff, ein linearer, verzweigter, cyclischer oder heterocyclischer unsubstituierter oder gegebenenfalls auch mit Heteroatomen substituierter organischer Rest ist. Besonders bevorzugt ist R² Wasserstoff oder Methyl und/oder R¹ ein linearer, verzweigter, cyclischer oder heterocyclischer unsubstituierter oder gegebenenfalls auch mit Heteroatomen substituierter organischer Rest.

Als Acrylate bzw. Methacrylate werden vorliegend Ester der Acrylsäure bzw. Methacrylsäure bezeichnet. Beispiele bevorzugt verwendbarer Acrylate und Methacrylate sind Phenylacrylat, Phenylmethacrylat, Phenoxyethylacrylat, Phenoxyethylmethacrylat, Phenoxyethoxyethylacrylat, Phenoxyethoxyethylmethacrylat, Phenylthioethylacrylat, Phenylthioethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Bisphenol A Diacrylat, Bisphenol A Dimethacrylat, sowie deren ethoxylierte Analogverbindungen, N-Carbazolylacrylate.

Als Urethanacrylate werden vorliegend Verbindungen mit mindestens einer Acrylsäureestergruppe und mindestens eine Urethanbindung verstanden. Solche Verbindungen können beispielsweise durch Umsetzung eines Hydroxy-funktionellen Acrylats oder Methacrylats mit einer Isocyanatfunktionellen Verbindung erhalten werden.

Beispiele hierfür verwendbarer Isocyanat-funktionelle Verbindungen sind Monoisocyanate sowie die unter a) genannten monomeren Diisocyanate, Triisocyanate und / oder Polyisocyanate. Beispiele geeigneter Monoisocyanate sind Phenylisocyanat, die isomeren Methylthiophenylisocyanate. Di-, Tri- oder Polyisocyanate sind oben genannt sowie Triphenylmethan-4,4',4"-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische Di-, Tri- oder Polyisocyanate.

Als hydroxyfunktionelle Acrylate oder Methacrylate für die Herstellung von Urethanacrylaten kommen beispielsweise Verbindungen wie 2-Hydroxyethyl(meth)acrylat, Polyethylenoxid-mono-(meth)acrylate, Polypropylenoxidmono(meth)acrylate, Polyalkylenoxidmono(meth)-acrylate, Poly(ε-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly(ε-caprolacton)mono(meth)acrylat.

Ebenfalls verwendet werden können die an sich bekannten hydroxylgruppenhaltigen Epoxy(meth)-acrylate mit OH-Gehalten von 20 bis 300 mg KOH/g oder hydroxylgruppenhaltige Polyurethan-(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten.

Bevorzugt sind insbesondere Urethanacrylate erhältlich aus der Umsetzung von Tris(p-isocyanatophenyl)thiophosphat und / oder m-Methylthiophenylisocyanat und/oder o-Phenylthiophenylacrylat und/oder o-Biphenylacrylat mit alkoholfunktionellen Acrylaten wie Hydroxyethyl(meth)acrylat, Hydroxypropyl(meth)acrylat und / oder Hydroxybutyl(meth)acrylat.

Ebenso ist es möglich, dass das Schreibmonomer weitere ungesättigte Verbindungen wie α,β-ungesättigte Carbonsäurederivate wie beispielsweise Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, α-Methylstyrol, Vinyltoluol und / oder Olefine, umfasst oder daraus besteht.

Gemäß einer weiteren bevorzugten Ausführungsform ist vorgesehen, dass das Photopolymer zusätzlich monomere Fluorurethane umfasst.

Besonders bevorzugt ist, wenn die Fluorurethane wenigstens eine Verbindung der Formel (II) 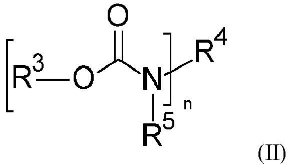 umfassen oder daraus bestehen, in der n ≥ 1 und n ≤ 8 ist und R³, R⁴, R⁵ unabhängig voneinander Wasserstoff, lineare, verzweigte, cyclische oder heterocyclische unsubstituierte oder gegebenenfalls auch mit Heteroatomen substituierte organische Reste sind, wobei bevorzugt mindestens einer der Reste R³, R⁴, R⁵ mit wenigstens einem Fluoratom substituiert ist und besonders bevorzugt R³ ein organischer Rest mit mindestens einem Fluoratom ist.

Gemäß einer weiteren bevorzugten Ausführungsform der Erfindung ist vorgesehen, dass das Photopolymer 10 bis 89,999 Gew.-%, bevorzugt 20 bis 70 Gew.-% Matrixpolymere, 3 bis 60 Gew.-%, bevorzugt 10 bis 50 Gew.-% Schreibmonomere, 0,001 bis 5 Gew.-%, bevorzugt 0,5 bis 3 Gew.-% Photoinitiatoren und gegebenenfalls 0 bis 4 Gew.-%, bevorzugt 0 bis 2 Gew.-% Katalysatoren, 0 bis 5 Gew.-% , bevorzugt 0,001 bis 1 Gew.-% Stabilisatoren, 0 bis 40 Gew.-%, bevorzugt 10 bis 30 Gew.-% monomere Fluorurethane und 0 bis 5 Gew.-%, bevorzugt 0.1 bis 5 Gew.-% weitere Additive enthält, wobei die Summe aller Bestandteile 100 Gew.-% beträgt.

Besonders bevorzugt werden Photopolymer mit 20 bis 70 Gew.-% Matrixpolymeren, 20 bis 50 Gew.-% Schreibmonomere, 0,001 bis 5 Gew.-% Photoinitiatoren, 0 bis 2 Gew.-% Katalysatoren, 0,001 bis 1 Gew.-% Radikalstabilisatoren gegebenenfalls 10 bis 30 Gew.-% Fluorurethane und gegebenenfalls 0.1 bis 5 Gew.-% weiterer Additive eingesetzt.

Als Katalysatoren können Urethanisierungskatalysatoren, wie z.B. organische oder anorganischen Derivate des Bimuths, des Zinns, des Zinks oder des Eisens (siehe dazu auch die in der US 2012/062658 genannten Verbindungen) verwendet werden. Besonders bevorzugte Katalysatoren sind Butylzinn-tris(2-ethylhexanoat), Eisen(III) - tris-acetylacetonat, Bismuth(III) tris(2-ethylhexanoat), und Zinn(II) bis(2-ethylhexanoat). Weiterhin können auch sterisch gehinderte Amine als Katalysatoren eingesetzt werden.

Als Stabilisatoren können Radikalinhibitoren wie HALS-Amine, N-Alkyl-HALS-, N-Alkoxy-HALS- und N-Alkoxyethyl-HALS-Verbindungen sowie Antioxidantien und / oder UV Absorber zum Einsatz kommen.

Als weitere Additive können Verlaufshilfsmittel und / oder Antistatika und / oder Thixotropiermittel und / oder Verdicker und / oder Biozide eingesetzt werden.

Die Photopolymerschicht B ist insbesondere eine solche, die nach dem Belichten mit UV-Strahlung einen mechanischen Modul Guv im Bereich zwischen 0,1 und 160 MPa aufweist. Insbesondere können die belichteten, holographischen Medien einen Modul Guv im Bereich zwischen 0,3 und 40, bevorzugt zwischen 0,7 und 15 MPa aufweisen.

Die Substratschicht C umfasst (Co)Polycarbonate, insbesondere aromatische Polycarbonate oder Copolycarbonate eignen sich in bevorzugten Ausführungsformen besonders. Die Polycarbonate oder Copolycarbonate können in bekannter Weise linear oder verzweigt sein. In eine anderen Ausführungsform kann die Substratschicht C ein Materialverbund wie ein Folienlaminat oder Coextrudat sein, welches auf einer Seite aus (Co)Polycarbonat besteht. Wenn im erfindungsgemäßen Verfahren ein (Co)Polycarbonat Folienlaminat oder Coextrudat verwendet wird, dann ist die der Photopolymerschicht B zugewandten Seite der Substratschicht C immer die (Co)polycarbonat-Seite. Bevorzugte Materialverbünde sind Duplex- und Triplexfolien aufgebaut nach einem der Schemata A/B, A/B/A oder A/B/C. Besonders bevorzugt sind PC/PMMA, PC/PA, PC/PET, und PC/TPU.

Das (Co)Polycarbonat der Substratschicht C kann unbehandelt (nativ) oder vorbehandelt sein, beispielsweise durch eine Flamm-, Korona-, Plasma- und / oder UV-Behandlung.

Vorzugsweise ist Substratschicht C im spektralen Bereich von 400-800 nm transparent.

Die Herstellung dieser Polycarbonate kann in bekannter Weise aus Dihydroxyarylverbindungen, Kohlensäurederivaten, gegebenenfalls Kettenabbrechern und gegebenenfalls Verzweigern erfolgen. Einzelheiten der Herstellung von Polycarbonaten sind in vielen Patentschriften seit etwa 40 Jahren niedergelegt. Beispielhaft sei hier nur auf Schnell, "Chemistry and Physics of Polycarbonates", Polymer Reviews, Volume 9, Interscience Publishers, New York, London, Sydney 1964, auf D. Freitag, U. Grigo, P. R. Müller, H. Nouvertne', BAYER AG, "Polycarbonates" in Encyclopedia of Polymer Science and Engineering, Volume 11, Second Edition, 1988, Seiten 648-718 und schließlich auf Dres. U. Grigo, K. Kirchner und P. R. Müller "Polycarbonate" in Becker/Braun, Kunststoff-Handbuch, Band 3/1, Polycarbonate, Polyacetale, Polyester, Celluloseester, Carl Hanser Verlag München, Wien 1992, Seiten 117-299 verwiesen.

Geeignete Dihydroxyarylverbindungen können beispielsweise Dihydroxyarylverbindungen der allgemeinen Formel (III) sein,

HO-Z-OH (III)

worin Z ein aromatischer Rest mit 6 bis 34 C-Atomen ist, der einen oder mehrere gegebenenfalls substituierte aromatische Kerne und aliphatische oder cycloaliphatische Reste bzw. Alkylaryle oder Heteroatome als Brückenglieder enthalten kann.

Beispiele für geeignete Dihydroxyarylverbindungen sind: Dihydroxybenzole, Dihydroxydiphenyle, Bis-(hydroxyphenyl)-alkane, Bis-(hydroxyphenyl)-cycloalkane, Bis-(hydroxyphenyl)-aryle, Bis-(hydroxyphenyl)-ether, Bis-(hydroxyphenyl)-ketone, Bis-(hydroxyphenyl)-sulfide, Bis-(hydroxyphenyl)-sulfone, Bis-(hydroxyphenyl)-sulfoxide, 1,1'-Bis-(hydroxyphenyl)-diisopropyl-benzole, sowie deren kernalkylierte und kernhalogenierte Verbindungen.

Diese und weitere geeignete andere Dihydroxyarylverbindungen sind z.B. in DE-A 3 832 396, FR-A 1 561 518, in H. Schnell, Chemistry and Physics of Polycarbonates, Interscience Publishers, New York 1964, S. 28 ff.; S.102 ff. und in D.G. Legrand, J.T. Bendler, Handbook of Polycarbonate Science and Technology, Marcel Dekker New York 2000, S. 72 ff. beschrieben.

Bevorzugte Dihydroxyarylverbindungen sind beispielsweise Resorcin, 4,4'-Dihydroxydiphenyl, Bis-(4-hydroxyphenyl)-methan, Bis-(3,5-dimethyl-4-hydroxyphenyl)-methan, Bis-(4-hydroxyphenyl)-diphenyl-methan, 1,1-Bis-(4-hydroxyphenyl)-1-phenyl-ethan, 1,1-Bis-(4-hydroxyphenyl)-1-(1-naphthyl)-ethan, 1,1-Bis-(4-hydroxyphenyl)-1-(2-naphthyl)-ethan, 2,2-Bis-(4-hydroxyphenyl)-propan, 2,2-Bis-(3-methyl-4-hydroxyphenyl)-propan, 2,2-Bis-(3,5-dimethyl-4-hydroxyphenyl)-propan, 2,2-Bis-(4-hydroxyphenyl)-1-phenyl-propan, 2,2-Bis-(4-hydroxyphenyl)-hexafluor-propan, 2,4-Bis-(4-hydroxyphenyl)-2-methyl-butan, 2,4-Bis-(3,5-dimethyl-4-hydroxyphenyl)-2-methylbutan, 1,1-Bis-(4-hydroxyphenyl)-cyclohexan, 1,1-Bis-(3,5-dimethyl-4-hydroxyphenyl)-cylohexan, 1,1-Bis-(4-hydroxyphenyl)-4-methyl-cylohexan, 1,3-Bis- [2-(4-hydroxyphenyl)-2-propyl]-benzol, 1,1'- Bis-(4-hydroxyphenyl)-3-diisopropyl-benzol, 1,1'-Bis-(4-hydroxyphenyl)-4-diisopropyl-benzol, 1,3-Bis-[2-(3,5-dimethyl-4-hydroxyphenyl)-2-propyl]-benzol, Bis-(4-hydroxyphenyl)-ether, Bis-(4-hydroxyphenyl)-sulfid, Bis-(4-hydroxyphenyl)-sulfon, Bis-(3,5-dimethyl-4-hydroxyphenyl)-sulfon und 2,2',3,3'-Tetrahydro-3,3,3',3'-tetramethyl-1,1'-spirobi-[1H-inden]-5,5'-diol oder

Dihydroxydiphenylcycloalkane der Formel (IIIa) 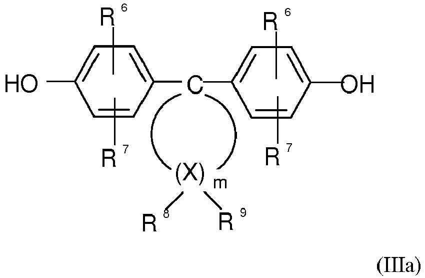 worin
R⁶ und R⁷ unabhängig voneinander Wasserstoff, Halogen, bevorzugt Chlor oder Brom, C₁-C₈-Alkyl, C₅-C₆-Cycloalkyl, C₆-C₁₀-Aryl, bevorzugt Phenyl, und C₇-C₁₂-Aralkyl, bevorzugt Phenyl-C₁-C₄-Alkyl, insbesondere Benzyl,
m eine ganze Zahl von 4 bis 7, bevorzugt 4 oder 5,
R⁸ und R⁹ für jedes X individuell wählbar, unabhängig voneinander Wasserstoff oder C₁-C₆-Alkyl und
X Kohlenstoff bedeuten,
mit der Maßgabe, dass an mindestens einem Atom X, R⁸ und R⁹ gleichzeitig Alkyl bedeuten. Bevorzugt sind in der Formel (IIIa) an einem oder zwei Atom(en) X, insbesondere nur an einem Atom X R⁸ und R⁹ gleichzeitig Alkyl.

Bevorzugter Alkylrest für die Reste R⁸ und R⁹ in Formel (IIIa) ist Methyl. Die X-Atome in alpha - Stellung zu dem Diphenylsubstituierten C-Atom (C-1) sind bevorzugt nicht dialkylsubstituiert, dagegen ist die Alkyldisubstitution in beta-Stellung zu C-l bevorzugt.

Besonders bevorzugte Dihydroxydiphenylcycloalkane der Formeln (IIIa) sind solche mit 5 und 6 Ring-C-Atomen X im cycloaliphatischen Rest (m = 4 oder 5 in Formel (IIIa)), beispielsweise die Dihydroxyarylverbindunge der Formeln (IIIa-1) bis (IIIa-3), 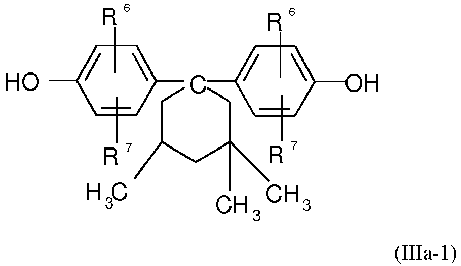 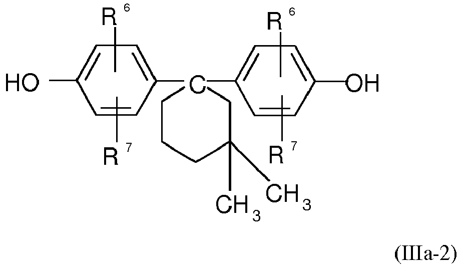 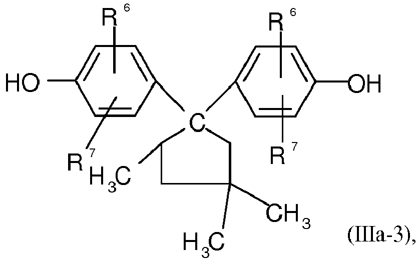 worin R⁶ und R⁷ die für Formel (III) genannte Bedeutung haben.

Ein ganz besonders bevorzugtes Dihydroxydiphenylcycloalkane der Formenl (IIIa) ist 1,1-Bis-(4-hydroxyphenyl)-3,3,5-trimethyl-cyclohexan (Formel (IIIa-1) mit R⁶ und R⁷ gleich H).

Solche Polycarbonate können gemäss der EP-A 359 953 aus Dihydroxydiphenylcycloalkanen der Formel (IIIa) hergestellt werden.

Besonders bevorzugte Dihydroxyarylverbindungen sind Resorcin, 4,4'-Dihydroxydiphenyl, Bis-(4-hydroxyphenyl)-diphenyl-methan, 1,1-Bis-(4-hydroxyphenyl)-1-phenyl-ethan, Bis-(4-hydroxyphenyl)-1-(1-naphthyl)-ethan, Bis-(4-hydroxyphenyl)-1-(2-naphthyl)-ethan, 2,2-Bis-(4-hydroxyphenyl)-propan, 2,2-Bis(3,5-dimethyl-4-hydroxyphenyl)-propan, 1,1-Bis-(4-hydroxyphenyl)-cyclohexan, 1,1-Bis-(3,5-dimethyl-4-hydroxyphenyl)-cyclohexan, 1,1-Bis-(4-hydroxyphenyl)-3,3,5-trimethyl-cyclohexan, 1,1'-Bis-(4-hydroxyphenyl)-3-diisopropyl-benzol und 1,1'- Bis-(4-hydroxyphenyl)-4-diisopropyl-benzol.

Ganz besonders bevorzugte Dihydroxyarylverbindungen sind 2,2-Bis-(4-hydroxyphenyl)-propan (BP-A) und 1,1-Bis-(4-hydroxyphenyl)-3,3,5-trimethyl-cyclohexan (BP-TMC).

Es können sowohl eine Dihydroxyarylverbindung unter Bildung von Homopolycarbonaten als auch verschiedene Dihydroxyarylverbindungen unter Bildung von Copolycarbonaten verwendet werden. Es können sowohl eine Dihydroxyarylverbindung der Formel (III) oder (IIIa) unter Bildung von Homopolycarbonaten als auch mehrere eine Dihydroxyarylverbindungen der Formel (III) und/oder (IIIa) unter Bildung von Copolycarbonaten verwendet werden. Dabei können die verschiedenen Dihydroxyarylverbindungen sowohl statistisch als auch blockweise miteinander verknüpft sein. Im Falle von Copolycarbonaten aus Dihydroxyarylverbindungen der Formel (III) und (IIIa), beträgt das molare Verhältnis von Dihydroxyarylverbindungen der Formel (IIIa) zu den gegebenenfalls mitzuverwendenden anderen Dihydroxyarylverbindungen der Formel (III) vorzugsweise zwischen 99 Mol-% (IIIa) zu 1 Mol-% (III) und 2 Mol-% (IIIa) zu 98 Mol-% (III), vorzugsweise zwischen 99 Mol-% IIIa) zu 1 Mol-% (I) und 10 Mol-% (IIIa) zu 90 Mol-% (III) und insbesondere zwischen 99 Mol-% (IIIa) zu 1 Mol-% (III) und 30 Mol-% (IIIa) zu 70 Mol-% (III).

Ein ganz besonders bevorzugtes Copolycarbonat kann unter Verwendung von 1,1-Bis-(4-hydroxyphenyl)-3,3,5-trimethyl-cyclohexan und 2,2-Bis-(4-hydroxyphenyl)-propan Dihydroxyarylverbindungen der Formel (IIIa) und (III) hergestellt werden.

Geeignete Kohlensäurederivate können beispielsweise Diarylcarbonate der allgemeinen Formel (IV) sein, 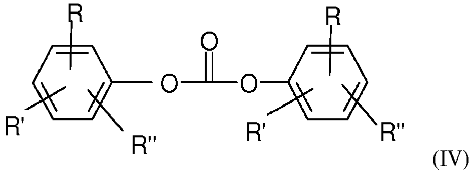 worin
R, R' und R" unabhängig voneinander gleich oder verschieden für Wasserstoff, lineares oder verzweigtes C₁-C₃₄-Alkyl, C₇-C₃₄-Alkylaryl oder C₆-C₃₄-Aryl stehen, R weiterhin auch -COO-R''' bedeuten kann, wobei R'" für Wasserstoff, lineares oder verzweigtes C₁-C₃₄-Alkyl, C₇-C₃₄-Alkylaryl oder C₆-C₃₄-Aryl steht.

Bevorzugte Diarylcarbonate sind beispielsweise Diphenylcarbonat, Methylphenyl-phenylcarbonate und Di-(methylphenyl)-carbonate, 4-Ethylphenyl-phenyl-carbonat, Di-(4-ethylphenyl)-carbonat, 4-n-Propylphenyl-phenyl-carbonat, Di-(4-n-propylphenyl)-carbonat, 4-iso-Propylphenyl-phenyl-carbonat, Di-(4-iso-propylphenyl)-carbonat, 4-n-Butylphenyl-phenyl-carbonat, Di-(4-n-butylphenyl)-carbonat, 4-iso-Butylphenyl-phenyl-carbonat, Di-(4-iso-butylphenyl)-carbonat, 4-tert-Butylphenyl-phenyl-carbonat, Di-(4-tert-butylphenyl)-carbonat, 4-n-Pentylphenyl-phenyl-carbonat, Di-(4-n-pentylphenyl)-carbonat, 4-n-Hexylphenyl-phenyl-carbonat, Di-(4-n-hexylphenyl)-carbonat, 4-iso-Octylphenyl-phenyl-carbonat, Di-(4-iso-octylphenyl)-carbonat, 4-n-Nonylphenylphenyl-carbonat, Di-(4-n-nonylphenyl)-carbonat, 4-Cyclohexylphenyl-phenyl-carbonat, Di-(4-cyclohexylphenyl)-carbonat, 4-(1-Methyl-1-phenylethyl)-phenyl-phenyl-carbonat, Di-[4-(1-methyl-1-phenylethyl)-phenyl]-carbonat, Biphenyl-4-yl-phenyl-carbonat, Di-(biphenyl-4-yl)-carbonat, 4-(1-Naphthyl)-phenyl-phenyl-carbonat, 4-(2-Naphthyl)-phenyl-phenyl-carbonat, Di-[4-(1-naphthyl)-phenyl] -carbonat, Di- [4-(2-naphthyl)phenyl] -carbonat, 4-Phenoxyphenyl-phenyl-carbonat, Di-(4-phenoxyphenyl)-carbonat, 3-Pentadecylphenyl-phenyl-carbonat, Di-(3-pentadecylphenyl)-carbonat, 4-Tritylphenyl-phenyl-carbonat, Di-(4-tritylphenyl)-carbonat, Methylsalicylat-phenyl-carbonat, Di-(methylsalicylat)-carbonat, Ethylsalicylat-phenyl-carbonat, Di-(ethylsalicylat)-carbonat, n-Propylsalicylat-phenyl-carbonat, Di-(n-propylsalicylat)-carbonat, iso-Propylsalicylat-phenyl-carbonat, Di-(iso-propylsalicylat)-carbonat, n-Butylsalicylat-phenyl-carbonat, Di-(n-butylsalicylat)-carbonat, iso-Butylsalicylat-phenyl-carbonat, Di-(iso-butylsalicylat)-carbonat, tert-Butylsalicylat-phenyl-carbonat, Di-(tert-butylsalicylat)-carbonat, Di-(phenylsalicylat)-carbonat und Di-(benzylsalicylat)-carbonat.

Besonders bevorzugte Diarylverbindungen sind Diphenylcarbonat, 4-tert-Butylphenyl-phenyl-carbonat, Di-(4-tert-butylphenyl)-carbonat, Biphenyl-4-yl-phenyl-carbonat, Di-(biphenyl-4-yl)-carbonat, 4-(1-Methyl-1-phenylethyl)-phenyl-phenyl-carbonat, Di-[4-(1-methyl-1-phenylethyl)-phenyl]-carbonat und Di-(methylsalicylat)-carbonat.

Ganz besonders bevorzugt ist Diphenylcarbonat.

Es können sowohl ein Diarylcarbonat als auch verschiedene Diarylcarbonate verwendet werden.

Zur Steuerung bzw. Veränderung der Endgruppen können zusätzlich beispielsweise eine oder mehrere Monohydroxyarylverbindung(en) als Kettenabbrecher eingesetzt werden, die nicht zur Herstellung des oder der verwendeten Diarylcarbonat(e) verwendet wurde(n). Dabei kann es sich um solche der allgemeinen Formel (V) handeln, 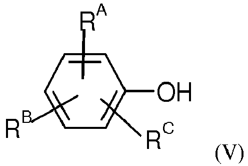 wobei
R^{A} für lineares oder verzweigtes C₁-C₃₄-Alkyl, C₇-C₃₄-Alkylaryl, C₆-C₃₄-Aryl oder für -COO-R^{D} steht, wobei R^{D} für Wasserstoff, lineares oder verzweigtes C₁-C₃₄-Alkyl, C₇-C₃₄-Alkylaryl oder C₆-C₃₄-Aryl steht, und
R^{B}, R^{C} unabhängig voneinander gleich oder verschieden für Wasserstoff, lineares oder verzweigtes C₁-C₃₄-Alkyl, C₇-C₃₄-Alkylaryl oder C₆-C₃₄-Aryl stehen.

Solche Monohydroxyarylverbindungen sind beispielsweise 1-, 2- oder 3-Methylphenol, 2,4-Dimethylphenol 4-Ethylphenol, 4-n-Propylphenol, 4-iso-Propylphenol, 4-n-Butylphenol, 4-isoButylphenol, 4-tert-Butylphenol, 4-n-Pentylphenol, 4-n-Hexylphenol, 4-iso-Octylphenol, 4-n-Nonylphenol, 3-Pentadecylphenol, 4-Cyclohexylphenol, 4-(1-Methyl-1-phenylethyl)-phenol, 4-Phenylphenol, 4-Phenoxyphenol, 4-(1-Naphthyl)-phenol, 4-(2-Naphthyl)-phenol, 4-Tritylphenol, Methylsalicylat, Ethylsalicylat, n-Propylsalicylat, iso-Propylsalicylat, n-Butylsalicylat, iso-Butylsalicylat, tert-Butylsalicylat, Phenylsalicylat und Benzylsalicylat.

Bevorzugt sind 4-tert-Butylphenol, 4-iso-Octylphenol und 3-Pentadecylphenol.

Geeignete Verzweiger können Verbindungen mit drei und mehr funktionellen Gruppen, vorzugsweise solche mit drei oder mehr Hydroxylgruppen.

Geeignete Verbindungen mit drei oder mehr phenolischen Hydroxylgruppen sind beispielsweise Phloroglucin, 4,6-Dimethyl-2,4,6-tri-(4-hydroxyphenyl)-hepten-2, 4,6-Dimethyl-2,4,6-tri-(4-hydroxyphenyl)-heptan, 1,3,5-Tri-(4-hydroxyphenyl)-benzol, 1,1,1-Tri-(4-hydroxyphenyl)-ethan, Tri-(4-hydroxyphenyl)-phenylmethan, 2,2-Bis-(4,4-bis-(4-hydroxyphenyl)-cyclohexyl]-propan, 2,4-Bis-(4-hydroxyphenyl-isopropyl)-phenol und Tetra-(4-hydroxyphenyl)-methan.

Sonstige geeignete Verbindungen mit drei und mehr funktionellen Gruppen sind beispielsweise 2,4-Dihydroxybenzoesäure, Trimesinsäure(trichlorid), Cyanursäuretrichlorid und 3,3-Bis-(3-methyl-4-hydroxyphenyl)-2-oxo-2,3-dihydroindol.

Bevorzugte Verzweiger sind 3,3-Bis-(3-methyl-4-hydroxyphenyl)-2-oxo-2,3-dihydroindol und 1,1,1-Tri-(4-hydroxyphenyl)-ethan.

Die Substratschicht C kann auch aus einer Mischung oder einem Copolymer von verschiedenen Bisphenoleinheiten bestehen.

Ganz besonders bevorzugt sind Polycarbonate oder Copolycarbonate, insbesondere mit mittleren Molekulargewichten Mw von 500 bis 100 000, bevorzugt von 10 000 bis 80 000, besonders bevorzugt von 15 000 bis 40 000 oder Blends enthaltend wenigstens ein solches Polycarbonat oder Copolycarbonat.

Geeignete Blends sind Blend aus Polycarbonat oder Copolycarbonat mit Acrylnitril-Butadien-Styrol-Copolymer (ABS), Polycarbonat oder Copolycarbonat mit Polyester(n) wie beispielsweise Polyalkylenterephthalat, insbesondere Polyethylenterephthalat und Polybutylenterephthalat, Polycarbonat oder Copolycarbonat mit Vinyl(Co)polymeren wie Polystyrolacrylnitril (SAN), Polymethylmethacrylat (PMMA) oder Copolymeren aus zwei Monomeren wie bespielsweise Methylmethacrylat/Styrolacrylnitril und Methylmethacrylat/Styrol. Bei einem solchen Blend aus Polycarbonat oder Copolycarbonat mit einem der oben genannten polymeren Blendpartner kann es sich bevorzugt um einen solchen mit 1 bis 90 Gew.-% Polycarbonat oder Copolycarbonat und 99 bis 10 Gew.-% polymeren Blendpartner, vorzugsweise mit 1 bis 90 Gew.-% Polycarbonat und 99 bis 10 Gew.-% polymeren Blendpartner handeln, wobei sich die Anteile zu 100 Gew.-% addieren. Vorzugsweise ist der Blend im spektralen Bereich von 400-800 nm transparent.

Materialien oder Materialverbünde der Substratschicht D basieren auf Polycarbonat (PC), Polyethylenterephthalat (PET), amorphe Polyester, Polybutylenterephthalat, Polyethylen, Polypropylen, Celluloseacetat, Cellulosehydrat, Cellulosenitrat, Cycloolefinpolymere, Polystyrol, hydriertem Polystyrol, Polyepoxide, Polysulfon, thermoplastisches Polyurethan (TPU), Cellulosetriacetat (CTA), Polyamid (PA), Polymethylmethacrylat (PMMA), Polyvinylchlorid, Polyvinylacetat, Polyvinylbutyral oder Polydicyclopentadien oder deren Mischungen. Besonders bevorzugt basieren sie auf PC, PET, PA, PMMA und CTA. Materialverbünde können Folienlaminate oder Coextrudate sein. Bevorzugte Materialverbünde sind Duplex- und Triplexfolien aufgebaut nach einem der Schemata A/B, A/B/A oder A/B/C. Besonders bevorzugt sind PC/PMMA, PC/PA, PC/PET, PET/PC/PET und PC/TPU. Vorzugsweise ist Substratschicht D im spektralen Bereich von 400-800 nm transparent.

Ein weiterer Gegenstand der Erfindung ist Schichtaufbaus umfassend eine Photopolymerschicht B, enthaltend ein Hologramm, und eine Substratschicht C aus (Co)Polycarbonat erhältlich oder erhalten nach dem erfindungsgemäßen Verfahren. Vorzugsweise weist der Schichtverbund eine Haftkraft in Anlehnung an ISO/IEC 10373 unter Verwendung einer Zugprüfmachinene nach DIN EN ISO 527-1 zwischen der Schicht B und C von mindestens 0,5 N/lOmm, vorzugsweise von mindestens 0,8 N/lOmm, bevorzugter von mindestens 0,9 N/lOmm, noch bevorzugter von mindestens 1,2 N/10mm auf. In einer anderen Ausführungsform weist der Schichtverbund eine Haftkraft in Anlehnung an ISO/IEC 10373 unter Verwendung einer Zugprüfmachinene nach DIN EN ISO 527-1 zwischen der Schicht B und C von mindestens 0,5 N/lOmm, vorzugsweise von mindestens 0,8 N/lOmm, bevorzugter von mindestens 0,9 N/lOmm, noch bevorzugter von mindestens 1,2 N/lOmm auf, wenn der Schichtverbund für 30 Sekunden auf mindestens 70° C erwärmt wurde. In einer bevorzugten Ausführungsform liegt die Photopolymerschicht B auf einer Substratschicht A vor, wobei die Schichten A und B klebstofffrei miteinander verbunden sind, wobei die Substratschicht A vorzugsweise eine transparente thermoplastische Substratschicht oder Glas ist. In einer bevorzugten Ausführungsform liegt die Substratschicht C auf einer Substratschicht D vor und ist mit dieser zumindest teilweise verbunden, vorzugsweise klebstofffrei verbunden, wobei die Substratschicht D vorzugsweise aus einem transparenten thermoplastischen Material oder einem Materialverbund besteht. In einer bevorzugten Ausführungsform ist die Substratschicht C eine aromatische Polycarbonatschicht, vorzugsweise eine aromatische Homopolycarbonatschicht, insbesondere eine Polycarbonatschicht wie oben definiert und erläutert.

Ein weiterer Gegenstand der Erfindung ist ein versiegeltes holographisches Medium enthaltend einen erfindungsgemäßen Schichtaufbau.

Ein weiterer Gegenstand der Erfindung ist ein geschütztes Hologramm bzw. holografisch optisches Element, dass durch das erfinderische Verfahren zur Herstellung eines zumindest teilweise verbundenen Aufbaus zugänglich ist. In einer Ausführungsform enthält des holographische Medium eine ein Hologram bzw. ein holographisch optisches Element enthaltende Photopolymerschicht mit einer Schichtdicke von 0.3 µm bis 500 µm, bevorzugt von 0.5 µm bis 200 µm und besonders bevorzugt von 1 µm bis 100 µm.

Insbesondere kann das Hologramm ein Reflektions-, Transmissions-, In-Line-, Off-Axis-, Full-Aperture Transfer-, Weißlicht-Transmissions-, Denisyuk-, Off-Axis Reflektions- oder Edge-Lit Hologramm sowie ein holographisches Stereogramm und bevorzugt ein Reflektions-, Transmissions- oder Edge-Lit Hologramm sein.

Mögliche optische Funktionen der Hologramme (als holografisch optisches Element) entsprechen den optische Funktionen von Lichtelementen wie Linsen, Spiegel, Umlenkspiegel, Filter, Streuscheiben, gerichteten Streuelementen, Beugungselemente, Lichtleiter, Lichtlenker (waveguides), Projektionsscheiben und/oder Masken. Zudem können mehrere derartiger optischer Funktionen in einem solchen Hologramm kombiniert werden, z.B. so dass je nach Lichteinfall das Licht in eine andere Richtung abgebeugt wird. So kann man beispielweise mit derartigen Aufbauten autostereoskopische oder holographische elektronische Displays bauen, die es erlauben einen stereoskopischen visuellen Eindruck ohne weitere Hilfsmittel wie z.B. einer Polarisator- oder Shutterbrille zu erleben, der Verwendung in automobilen Head-up Displays oder Head-mounted Displays.

Häufig zeigen diese optischen Elemente eine spezifische Frequenzselektivität, je nachdem wie die Hologramme belichtet wurden und welche Dimensionen das Hologramm hat. Dies ist insbesondere wichtig, wenn man monochromatische Lichtquellen wie LED oder Laserlicht verwendet. So benötigt man ein Hologramm pro Komplementärfarbe (RGB), um Licht frequenzselektiv zu lenken und gleichzeitig vollfarbige Displays zu ermöglichen. Daher sind in bestimmten Displayaufbauten mehrer Hologramme ineinander im Medium zu belichten.

Zudem können mittels der erfindungsgemäßen versiegelten holophaphischen Medien auch holographische Bilder oder Darstellungen, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten hergestellt werden. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar. Auch ist es möglich derartige Hologramme zur Speicherung digitaler Daten zu verwenden, wobei verschiedenste Belichtungsverfahren (Shift-, Spatial- oder Angular- Multiplexing) verwendet werden.

Ebenfalls Gegenstand der Erfindung ist eine optische Anzeige, umfassend ein erfindungsgemäßes versiegeltes holographisches Medium.

Beispiele für derartige optische Anzeigen sind bildgebende Anzeigen auf Basis von Flüssigkristallen, organischen lichtemittierenden Dioden (OLED), LED-Displaytafeln, Microelektromechanische Systeme (MEMS) auf Basis von diffraktiver Lichtselektion, Electrowettingdisplays (E-ink) und Plasmabildschirmen. Derartige optische Anzeigen können autostereoskopische und/oder holographische Displays, transmittive und reflektive Projektionsleinwände oder Projektionsscheiben, Displays mit schaltbaren eingeschränkten Abstrahlverhalten für Privacyfilter und bidirektionalen Multiuserbildschirmen, virtuelle Bildschirme, Headup-Displays, Head-mounted Displays, Leuchtsymbole, Warnlampen, Signallampen, Scheinwerfer und Schautafeln sein.

Ebenfalls Gegenstand der Erfindung sind autostereoskopische und/oder holographische Displays, Projektionsleinwände, Projektionsscheiben, Displays mit schaltbaren eingeschränkten Abstrahlverhalten für Privacyfilter und bidirektionalen Multiuserbildschirmen, virtuelle Bildschirme, Headup-Displays, Head-mounted Displays, Leuchtsymbole, Warnlampen, Signallampen, Scheinwerfer und Schautafeln umfassend ein erfindungsgemäßes holographisches Medium.

Noch weitere Gegenstände der Erfindung sind ein Sicherheitsdokument und ein holographisch optisches Element umfassend ein erfindungsgemäßes versiegeltes holographisches Medium.

Darüber hinaus ist auch die Verwendung eines erfindungsgemäßen holographischen Mediums zur Herstellung von Chipkarten, Ausweisdokumenten, 3D-Bildern, Produktschutzetiketten, Labeln, Banknoten oder holographisch optischen Elementen insbesondere für optische Anzeigen sind Gegenstand der Erfindung.

### Beispiele

### Chemikalien:

In eckigen Klammern ist jeweils, soweit bekannt, die CAS-Nummer angegeben.

| **Rohstoffe der Photopolymerschicht B** | |
|---|---|
| 2-Hydroxyethylacrylat | [818-61-1] - Sigma-Aldrich Chemie GmbH Steinheim, Deutschland |
| 2,6-Di-tert.-butyl-4-methylphenol | [128-37-0] - Merck KGaA, Darmstadt, Germany |
| 3-(Methylthio)phenylisocyanat | [28479-19-8] - Sigma-Aldrich Chemie GmbH Steinheim, Deutschland |
| Desmodur® RFE | [141-78-6] Tris(p-isocyanatophenyl)thiophosphat, 27%-ig in Ethylacetat, Produkt der Covestro DeutschlandAG, Leverkusen, Deutschland |
| Dibutylzinndilaurat | [77-58-7] - Sigma-Aldrich Chemie GmbH Steinheim, Deutschland |
| Fomrez® UL 28 | Momentive Performance Chemicals, Wilton, CT, USA. |
| Borchi® Kat 22 | [85203-81-2] - OMG Borchers GmbH, Langenfeld, Deutschland. |
| Desmodur® N 3900 | [28182-81-2] Covestro DeutschlandAG, Leverkusen, DE, Hexandiisocyanatbasiertes Polyisocyanat, Anteil an Iminooxadiazindion mindestens 30 %, NCO-Gehalt: 23.5 %. |
| Desmorapid® SO | [301-10-0] - Rhein Chemie Rheinau GmbH, Mannheim, Deutschland |
| CGI-909 | [1147315-11-4] Tetrabutylammonium-tris(3-chlor-4-methylphenyl)(hexyl)borat, BASF SE |
| Trimethylhexamethylendiisocyanat | [28679-16-5] - ABCR GmbH & Co KG, Karlsruhe, Deutschland |
| 1H,1H-7H-Perfluorheptan-1-ol | [335-99-9] - ABCR GmbH & Co KG, Karlsruhe, Deutschland |
| Astrazon Rosa FG 200% | [3648-36-0] - DyStar Colours Deutschland GmbH, Frankfurt am Main, Deutschland |
| Natrium-bis(2-ethylhexyl)sulfosuccinat | [45297-26-5] Sigma-Aldrich Chemie GmbH, Steinheim, Deutschland |
| Polytetrahydrofuranpolyetherpolyols | |

| **Additive** | |
|---|---|
| BYK 310 - Verlaufsmittel | Silikonhaltiges Oberflächenadditiv der Fa. BYK-Chemie GmbH, Wesel, Deutschland |
| Tinuvin 292 - Lichtstabilisator | Ein sterisch gehindertes Amin der Fa. BASF SE, Ludwigshafen, Deutschland. |
| Irganox 1135 - Antioxidant | Ein phenolisches Antioxidanz der Fa. BASF SE, Ludwigshafen, Deutschland. |

| **Lösemittel** | |
|---|---|
| Butylacetat (BA) | Essigsäurebutylester der Brenntag GmbH, Mülheim an der Ruhr, Deutschland. |
| Methoxypropanol (MP) | 1-Methoxy-2-propanol der Brenntag GmbH, Mülheim an der Ruhr, Deutschland. |
| MPA-EEP (M/E) | Eine 50:50 Gew.-%-Mischung aus 1-Methoxy- 2-propanolacetat (DOWANOL™ PMA GLYCOL ETHER ACETATE) der DOW Deutschland Anlagengesellschaft mbH, Schwalbach, Deutschland und Ethyl-3-Ethoxypropionat der Brenntag GmbH, Mülheim an der Ruhr, Deutschland. |

| **Folien** | |
|---|---|
| Makrofol DE 1-1 | Eine Bisphenol-A (BP-A-PC) basierende Polycarbonatfolie der Covestro Deutschland AG, Leverkusen, DE, mit glatter Oberfläche auf Vorder- und Rückseite. |
| Bayfol OX503 | Eine Bisphenol-A (BP-A-PC) basierende Polycarbonatfolie der Covestro Deutschland AG, Leverkusen, DE, mit glatter Oberfläche auf Vorder- und Rückseite. |
| Hostaphan | Polyethylenglycolterephtalat (PET) Folie der Firma Mitsubishi Chemical Europe GmbH, Düsseldorf, Deutschland.. |
| Tacphan | Cellulose triacetate (TAC) Folie der Firma LOFO High Tech Film GmbH, Weil am Rhein, Deutschland. |
| Transphan | Polyamide (PA) Folie der Firma LOFO High Tech Film GmbH, Weil am Rhein, Deutschland. |
| Pokalon | Polycarbonat (PC) Folie der Firma LOFO High Tech Film GmbH, Weil am Rhein, Deutschland. |
| Plexiglas | Polymethylmethacrylat (PMMA) platte der Firma Evonik Industries AG, Essen, Deutschland. |

### Urethanacrylat 1: Phosphorothioyltris(oxybenzol-4,1-diylcarbamoyloxyethan-2,1-diyl)tris-acrylat

In einem 500 mL Rundkolben wurden 0.1 g 2,6-Di-tert.-butyl-4-methylphenol, 0.05 g Dibutylzinndilaurat sowie und 213.1 g einer 27 %-igen Lösung von Tris(p-isocyanatophenyl)thiophosphat in Ethylacetat (Desmodur® RFE, Produkt der Covestro DeutschlandAG, Leverkusen, Deutschland) vorgelegt und auf 60 °C erwärmt. Anschließend wurden 42.4 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

### Urethanacrylat 2: 2-({[3-(Methylsulfanyl)phenyl]carbamoyl}oxy)ethylprop-2-enoat

In einem 100 mL Rundkolben wurden 0.02 g 2,6-Di-tert.-butyl-4-methylphenol, 0.01 g Dibutylzinndilaurat, 11.7 g 3-(Methylthio)phenylisocyanat vorgelegt und auf 60 °C erwärmt. Anschließend wurden 8.2 g 2-Hydroxyethylacrylat zugetropft und die Mischung weiter auf 60 °C gehalten, bis der Isocyanatgehalt unter 0.1 % gesunken war. Danach wurde abgekühlt. Das Produkt wurde als farblose Flüssigkeit erhalten.

### Polyol-Komponente:

In einem 1 L Kolben wurden 0.037 g Desmorapid® SO, 374.8 g ε-Caprolacton und 374.8 g eines difunktionellen Polytetrahydrofuranpolyetherpolyols vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

### Farbstoff 1:

5.84 g wasserfreies Natrium-bis(2-ethylhexyl)sulfosuccinat wurden in 75 mL Essigsäureethylester gelöst. 14.5 g des Farbstoffs Astrazon Rosa FG 200%, gelöst in 50 mL Wasser, wurden zugesetzt. Die wässrige Phase wurde abgetrennt und die organische Phase wurde dreimal mit 50 ml frischem Wasser bei 50 °C verrührt und jedes Mal die wässrige Phase abgetrennt, die letzte bei Raumtemperatur. Nach Abtrennen der wässrigen Phase wurde das Lösungsmittels im Vakuum abdestilliert und man erhielt 8.6 g 3H-Indolium, 2-[2-[4-[(2-chloroethyl)methylamino]phenyl]ethenyl]-1,3,3-trimethyl-1,4-bis(2-ethylhexyl) sulfosuccinat [153952-28-4] als hochviskoses Öl.

### Fluoriertes Urethan: Bis(2,2,3,3,4,4,5,5,6,6,7,7-dodecafluoroheptyl)-(2,2,4-trimethyl-hexane-1,6-diyl)biscarbamat

In einem 6 L-Rundkolben wurden 0.50 g Dibutylzinndilaurat und 1200 g Trimethylhexamethylendiisocyanat vorgelegt und auf 80 °C erwärmt. Anschließend wurden 3798 g 1H,1H,7H-Perfluorheptan-1-ol zugetropft und die Mischung weiter auf 80 °C gehalten, bis der Isocyanatgehalt unter 0.1 % gesunken war. Danach wurde abgekühlt. Das Produkt wurde als farbloses Öl erhalten.

### Herstellung holographischer Medien (Photopolymerfolie)

7.90 g der oben beschriebenen Polyol-Komponente wurden aufgeschmolzen und mit 7.65 g des jeweiligen Urethanacylats 2, 2.57 g des oben beschriebenen Urethanacrylats 1, 5.10 g des oben beschriebenen fluorierten Urethans, 0.91 g CGI 909, 0.232 g des Farbstoff 1, 0.230 g BYK 310, 0.128 g Fomrez UL 28 und 3.789 g Ethylacetat gemischt, so dass eine klare Lösung erhalten wurde. Anschließend wurden 1.50 g Desmodur® N 3900 zugegeben und erneut gemischt.

Nun gab man diese Lösung in einer Rolle zu Rolle Beschichtungsanlage auf eine 66 µm dicke Polycarbonat Trägerfolie, wo mittels eines Rakels das Produkt in einer Naßschichtdicke von 19 µm appliziert wurde. Bei einer Trocknungstemperatur von 85 °C und einer Trocknungszeit von 5 Minuten wurde die beschichtete Folie getrocknet und anschließend mit einer 40 µm dicken Polyethylenfolie geschützt. Anschließend wurde dieser Film lichtdicht verpackt.

### Herstellung und Charakterisierung von Testhologrammen

Testhologramme wurden wie folgt vorbereitet: die Photopolymerfolien wurden im Dunkeln auf die gewünschte Größe zurechtgeschnitten und mit Hilfe einer Gummiwalze auf eine Glasplatte der Maße 50 mm x 70 mm (3 mm Dicke) auflaminiert.

Die Herstellung von Testhologrammen erfolgt durch eine Testapparatur, die mittels grüner (532nm) Laserstrahlung Denisyuk-Reflektionshologramme erzeugt. Die Testapparatur besteht aus einer Laserquelle, einem optischen Strahlführungssystem und einer Halterung für die Glascoupons. Die Halterung für die Glascoupons ist mit einem Winkel von 13° relativ zur Strahlachse montiert. Die Laserquelle generierte die Strahlung, die über einen speziellen optischen Strahlengang auf ca 5 cm aufgeweitet zum Glascoupon geführt wurde, der sich im optischen Kontakt zum Spiegel befand. Das holographierte Objekt war ein ca. 2 cm x 2 cm großer Spiegel, so dass bei der Rekonstruktion des Holograms die Wellenfront des Spiegels rekonstruiert wurde. Alle 15 Beispiele wurden mit einem grünen 532nm Laser (Newport Corp, Irvine, CA, USA, Best.- Nr. EXLSR-532-50-CDRH) belichtet. Mittels Verschlussblende wurde der Aufzeichnungsfilm definiert für 2 Sekunden belichtet.

### UV Belichtung / Belichtung mit aktinischer Strahlung

Die Proben wurden mit der Trägerschichtseite zur Lampe hin auf das Förderband eines UV-Strahlers gelegt und mit einer Bahngeschwindigkeit von 2,5 m/min zwei Mal belichtet. Als UV-Strahler wurde eine eisendotierte Hg-Lampe vom Typ Fusion UV type "D Bulb" No. 558434 KR 85 mit 80 W / cm² Gesamtleistungsdichte verwendet. Die Parameter entsprachen einer Dosis von 2 x 2,5 J/cm² (gemessen mit einem Light Bug des Typs ILT 490).

### Analyse des Hologramms auf Frequenzberschiebung ("Shift")

Diese diffraktive Reflexion lässt sich aufgrund der hohen Effizienz des Volumenhologramms mit sichtbarem Licht mit einem VIS-Spektrometer (USB 2000, Ocean Optics, Dunedin, FL, USA) in Transmission analysieren und erscheint im Transmissionsspektrum als Peak mit reduzierter Transmission. Über die Auswertung der Transmissionskurve lässt sich die Qualität des Hologramms feststellen: Die Breite des Peaks wurde als "Full width at half maximum" (FWHM) in Nanometern (nm) bestimmt, die Tiefe des Peaks (Tmin) wurde 30 als 100% - Tmin in Prozent angegeben (1-Tₘᵢₙ), der Bereich mit niedrigster Transmission gibt die Wellenlänge (ₚₑₐₖ) höchster Beugungseffizienz an.

### Untersuchung der Haftung in Folienverbund

Der Zusammenhalt aller Schichten des Folienverbunds wurde nach eigener Methode untersucht. Dabei wurde die Photopolymerfolie Bund die darüber aufgebrachte Substratfolie C per Hand auseinander gezogen. Die Ergebnisse wurden in folgenden Stufen von voller Haftung (Kennwert: 0) bis zur keiner Haftung (Kennwert: 5) quantifiziert:
0 - Haftung ist so stark, dass der Folienverbund nicht zerstörungsfrei getrennt werden kann;
1 - Starke Haftung, lässt sich nur unter erheblichen manuellen Kraftaufwand abziehen;
2 - Mittelstarke Haftung, lässt sich unter manuellen Kraftaufwand abziehen.;
3 - Mittlere Haftung, lässt sich unter geringem Kraftaufwand abziehen;
4 - Leichte Haftung, lässt sich unter leichtem Kraftaufwand abziehen;
5 - Sehr schwache bzw. keine Haftung. Folienverbund haftet nur an.

### Nicht erfinderische Beispiele A-C, erfinderisches Beispiel 1

Ein 5 cm x 7 cm großes Folienstück der Photopolymerfolie wurde im Dunkeln zugeschnitten (5x7cm) und die PE Kaschierung wurde entfernt. Anschließend wurde die Photopolymeroberfläche mit einer Polycarbonatfolie (Makrofol DE 1-1, Dicke 125µm) mittels eines Rollenlaminator (Dumor Trident 46; Laminationsgeschwindigkeit: 0,3 m/min, Rollendruckeinstellung: High; Kontakzeit: ca. 0,5 sec) bei verschiedenen Rollentemperaturen zusammenlaminiert. Danach wurde ein Reflektionshologramm bei 532nm geschrieben und die Probe mit UV-licht (5 J/cm2) vollständig geblichen. Die Proben wurden spektrometrisch und hinsichtlich der Haftung zwischen Photopolymer und Polycarbonatfolie (Makrofol DE 1-1, Dicke 125µm) charakterisiert. Die Ergebnisse sind in Tabelle 1 zusammengefasst.

**Tabelle 1: Charakterizierung der Beispiele A-C und 1 hinsichtlich Hologramm und Haftung**

| **Beispiel** | **Laminations-Temperatur** | **1-Tₘᵢₙ [%]** | **λₚₑₐₖ [nm]** | **Shift vs Referenz [nm]** | **Haftung 0 (sehr stark) bis 5 (sehr gering)** |
|---|---|---|---|---|---|
| **A** | 60°C | 85,5 | 532 | 2,1 | 5 |
| **1** | 100°C | 84,4 | 533 | 2,8 | 3 |
| **B** | 120°C | - | - | - | Blasenbildung |
| **C** | 140°C | - | - | - | Blasenbildung |

Im erfinderischen Beispiel 1 wurde ein geringer Hologrammshift (vs Referenzprobe) gemessen, wobei eine mittlere Haftung zwischen Photopolymer und Polycarbonat Folie gemessen wurde. In den nicht erfinderischen Beispiel A wird keine Haftungsverbesserung gefunden. In den nicht erfinderischen Beispielen B und C, zeigten die Folien eine starke Blasenbildung.

### Nicht erfinderische Beispiele D-F, erfinderisches Beispiel 2

Ein 5 cm x 7 cm großes Folienstück der Photopolymerfolie wurde im Dunkeln zugeschnitten (5x7cm) und die PE Kaschierung wurde entfernt. Anschließend wurde die Photopolymeroberfläche mit einer Polycarbonatfolie (Makrofol DE 1-1, Dicke 125µm) mittels eines Rollenlaminator (Dumor Trident 46; Laminationsgeschwindigkeit: 0,3 m/min, Rollendruckeinstellung: High) bei Raumtempertur zusammenlaminiert. Danach wurde ein Reflektionshologramm bei 532nm geschrieben und die Probe wurde nochmals mittels Rollenlaminator bei verschiedenen Rollentemperaturen laminiert und anschließend mit UV-licht (5 J/cm2) vollständig geblichen. Die Proben wurden spektrometrisch und hinsichtlich der Haftung charakterisiert. Die Ergebnisse sind in Tabelle 2 zusammengefasst.

**Tabelle 2: Charakterizierung der Beispiele D-F und 2 hinsichtlich Hologramm und Haftung**

| **Beispiel** | **Laminations-Temperatur** | **1-Tₘᵢₙ [%]** | **lₚₑₐₖ [nm]** | **Shift vs Referenz [nm]** | **Haftung 0 (sehr stark) bis 5 (sehr gering)** |
|---|---|---|---|---|---|
| D | RT | 82,6 | 535 | 4,9 | 5 |
| 2 | 100°C | 81,4 | 533 | 3,5 | 3 |
| E | 120°C | - | - | - | Blasenbildung |
| F | 140°C | - | - | - | Blasenbildung |

Im erfinderischen Beispiel 2 wurde eine mittlere Haftung bestimmt, wobei ein geringer Hologrammshift (vs Referenzprobe) gemessen wurde. In dem nicht erfinderischen Beispiel D wird keine Haftung gefunden, in den nicht erfinderischen Beispielen E und F zeigte sich eine starke Blasenbildung.

### Nicht erfinderische Beispiele G-I, erfinderische Beispiele 3-6

Ein 5 cm x 7 cm großes Folienstück der Photopolymerfolie wurde im Dunkeln zugeschnitten (5x7cm) und die PE Kaschierung wurde entfernt. Anschließend wurde die Photopolymeroberfläche auf Glas auflaminiert und ein Reflektionshologramm bei 532 nm geschrieben. Anschließend wurde die Folie vom Glas delaminiert und die Photopolymeroberfläche auf eine Polycarbonatfolie (Makrofol DE 1-1, Dicke 125µm) mittels eines Rollenlaminator (Dumor Trident 46; Laminationsgeschwindigkeit: 0,3 m/min, Rollendruckeinstellung: High) bei verschiedenen Laminatorrollentemperaturen zusammenlaminiert. Danach wurde mit UV-licht (5 J/cm2) vollständig geblichen. Die Proben wurden spektrometrisch und hinsichtlich der Haftung charakterisiert. Die Ergebnisse sind in Tabelle 3 zusammengefasst.

**Tabelle 3: Charakterizierung der Beispiele G-I und 3-6 hinsichtlich Hologramm und Haftung**

| **Beispiele** | **Laminations-Temperatur** | **1-Tₘᵢₙ [%]** | **λₚₑₐₖ [nm]** | **Shift vs Referenz [nm]** | **Haftung 0 (sehr stark) bis 5 (sehr gering)** |
|---|---|---|---|---|---|
| G | RT | 93,4 | 529 | -1,0 | 5 |
| 3 | 70°C | 93,5 | 529 | -1,0 | 4 |
| 4 | 80°C | 93,9 | 529 | -1,0 | 3-4 |
| 5 | 100°C | 94,5 | 530 | 0,3 | 3 |
| 6 | 110°C | 94,7 | 530 | 0,3 | 2 |
| H | 120°C | - | - | - | Blasenbildung |
| I | 140°C | - | - | - | Blasenbildung |

In den erfinderischen Beispielen 3 bis 6 wurde ein geringer Hologrammshift (vs Referenzprobe) gemessen, während die Haftung zwischen Photopolymer und Polycarbonat Folie mit der Temperatur deutlich stieg. Im nicht erfinderischen Beispiel G wird keine Haftung beobachtet. In den nicht erfinderischen Beispielen H und I, zeigten die Folien eine starke Blasenbildung.

### Nicht erfinderisches Beispiel L, erfinderische Beispiele 7-12

Ein 5 cm x 7 cm großes Folienstück der Photopolymerfolie wurde im Dunkeln zugeschnitten (5x7cm) und die PE Kaschierung wurde entfernt. Anschließend wurde die Photopolymeroberfläche auf Glas auflaminiert und ein Reflektionshologramm bei 532 nm geschrieben. Anschließend wurde die Folie vom Glas delaminiert und die Photopolymeroberfläche wurde mit einer Polycarbonatfolie (Makrofol DE 1-1, Dicke 125µm) mittels eines Rollenlaminator (Dumor Trident 46; Laminationsgeschwindigkeit: 0,3 m/min, Rollendruckeinstellung: High) bei Raumtemperatur zusammenlaminiert. Anschließend wurde bei verschiedenen Temperaturen im Ofen der Aufbau getempert. Die Proben wurden mit UV-Licht-Behandlung (5 J/cm2) direkt anschließend nach der Erwärmung im Ofen belichtet. Abschließend wurden die Proben spektrometrisch und hinsichtlich der Haftung charakterisiert. Die Ergebnisse und die experimentellen Paramtern sind in Tabelle 4 zusammengefasst.

**Tabelle 4: Charakterizierung der erfinderischen Beispiele 7-12 und des nicht erfinderischen Beispiels L hinsichtlich Hologrammstabilität und Haftung**

| **Beispiel** | **Ofen-Temp. (°C)** | **Lagerzeit im Ofen (sec.)** | **Zeit zwischen Ofen und UV-schritt (min)** | **1-Tₘᵢₙ [%]** | **λₚₑₐₖ [nm]** | **Shift vs Referenz [nm]** | **Haftung 0 (sehr stark) bis 5 (sehr gering)** |
|---|---|---|---|---|---|---|---|
| 7 | 100 | 20 | 5 min | 93,3 | 527 | -3,4 | 4 |
| 8 | 100 | 30 | 5 min | 96,2 | 529 | -1,3 | 4 |
| 9 | 100 | 50 | 5 min | 96,4 | 528 | -1,7 | 3 |
| 10 | 100 | 70 | 5 min | 95,3 | 529 | -0,6 | 3 |
| 11 | 100 | 90 | 5 min | 95,5 | 528 | -2,4 | 2 |
| 12 | 100 | 120 | 5 min | 95,9 | 529 | -1,0 | 2 |
| L | 120 | 30 | 5 min | - | - | - | Blasenbildung |

In den erfinderischen Beispielen 7 bis 12 wurde ein geringer, akzeptabler Hologrammshift gemessen, während die Haftung zwischen Photopolymer und Polycarbonat Folie mit der Temperatur stieg. Im nicht erfinderischen Beispiel L, zeigte sich eine starke Blasenbildung. Die Beipiele 9-12 sind bevorzugt (Lagerzeit > 50 Sekuden bei 100°C Ofentemperatur), wobei Beispiel 11-12 (Lagerzeit von > 90 Sekunden bei 100°C Ofentemperatur) besonders bevorzugt sind.

### Nicht erfinderische Beispiele M-S, erfinderische Beispiele 13-15

Ein 5 cm x 7 cm großes Folienstück Photopolymerfolie wurde im Dunkeln zugeschnitten (5x7cm) und die PE Kaschierung wurde entfernt. Anschließend wurde die Photopolymeroberfläche auf verschiedene thermoplastische Kunststofffolien mittels Rollenlaminator (Dumor Trident 46; Laminationsgeschwindigkeit: 0,3 m/min, Rollendruckeinstellung: High) bei Raumtemperatur zusammenlaminiert. Anschließend wurde der Aufbau bei 100°C für 20 Sekunden im Ofen getempert. Details der Experimente und die Ergebnisse sind in Tabelle 5 zusammengefasst.

**Tabelle 5: Haftung zwischen Photopolymerschicht und verschiedenen auflaminierten thermoplastischen Kunstofffolien sowie Glas.**

| **Beispiel** | **Auflaminierte Kunstofffolien** | **Material der Substratfolie** | **Haftung 0 (sehr stark) bis 5 (sehr gering)** |
|---|---|---|---|
| 13 | Bayfol OX503 66µm | BP-A-Polycarbonat | 2 |
| 14 | Makrofol 1-1 125µm | BP-A-Polycarbonat | 2 |
| M | Transphan 60µm | Polyamid | 5 |
| N | Tacphan 50µm | Cellulosetriacetat | 5 |
| 15 | Pokalon 60µm | BP-TMC-Polycarbonat | 2-3 |
| O | Hostaphan 36µm | Polyethylenglycolterephthalat | 5 |
| P | Hostaphan 23µm | Polyethylenglycolterephthalat | 5 |
| Q | Hostaphan 50µm | Polyethylenglycolterephthalat | 5 |
| R | Plexiglas 1.5 mm | Polymethylmethacrylat | 5 |
| s | Glas | Sodaglas | 5 |

Eine gute Haftung wurde nur in den erfinderischen Beispielen 13, 14 und 15 mit PC basierten Folien erzeugt. In den nicht erfinderischen Beispielen M bis S mit nicht Polycarbonat basierten Materialien bleibt die Haftung nach der Verarbeitung gering.

### Nicht erfinderisches Beispiel T, erfinderische Beispiele 16-19

Ein 15 cm x 20 cm großes Folienstück einer Photopolymerfolie mit der Dicke von 25 µm wurde im Dunkeln zugeschnitten (15x20cm) und die PE Kaschierung wurde entfernt. Anschließend wurde die Photopolymeroberfläche auf eine Polycarbonat Folie (Makrofol DE 1-1, dicke 125µm) (Dumor Trident 46; Laminationsgeschwindigkeit: 0,3 m/min, Rollendruckeinstellung: High) bei Raumtemperatur zusammenlaminiert. Anschließend wurde bei verschiedenen Temperaturen und Zeiten im Ofen der Aufbau getempert. Anschließend wurden die Proben mit UV-Licht (5 J/cm2) vollständig geblichen. Jede Folie wurde in mind. 6 verschiedene 10 mm Breite Streifen zugeschnitten. Die Haftkräfte zwischen Photopolymer und Polycarbonat Folie erfolgte in Anlehnung an ISO/IEC 10373 mit einer Zugprüfmaschine gemäß DIN EN ISO 527-1. Details der Experimente und die Ergebnisse sind in Tabelle 6 zusammengefasst. Die Haftkraftangaben in der Tabelle entsprechen dabei dem Mittelwert von sechs Einzelmessungen an gleich präparierten Proben.

**Tabelle 6: Haftkräfte (in N/lOmm) gemessen zwischen Photopolymerschicht B und auflaminierter Polycarbonat-Folie (Substratschicht C)**

| **Beispiele** | **Ofen Temp. (°C)** | **Temperierungszeit** | **Haftkraft [N/10mm]** | **Haftung 0 (sehr stark) bis *5 (sehr gering)*** |
|---|---|---|---|---|
| T | 60 | 5 min | 0,3 | 5 |
| 16 | 70 | 30 sek | 1,3 | 3 |
| 17 | 100 | 30 sek | 4,8 | 1 |
| 18 | 100 | 10 min | 13,0 | 0 |
| 19 | 110 | 30 sek | 4,6 | 1 |

In den erfinderichen Beispielen 17 bis 19 wurde eine sehr gute Haftkraft erhalten und diese stieg in Abhängigkeit von der Ofentemperatur und der Zeit. In Beispiel 19 wurde eine sehr hohe Haftkraft von 13 N/lOmm erhalten, sodas der Schichtaufbau nicht mehr zerstörungsfrei getrennt werden kann.

### Erfinderische Beispiele 20 und 21

Ein 15 cm x 20 cm großes Folienstück Photopolymerfolie in 15 µm Dicke wurde im Dunkeln zugeschnitten (15x20cm) und die PE Kaschierung wurde entfernt. Anschließend wurde die Photopolymeroberfläche auf Glas auflaminiert und Reflektionshologramme wurden mit verschiedener Schreibdosis bei 532nm geschrieben. Anschließend wurden diese vom Glas im Dunkeln delaminiert und auf eine Polycarbonat Folie (Makrofol DE 1-1, dicke 125µm) (Dumor Trident 46; Laminationsgeschwindigkeit: 0,3 m/min, Rollendruckeinstellung: High) bei Raumtemperatur auflaminiert. Anschließend wurde im Ofen bei 100°C für 20 Sekunden getempert. Anschließend wurden die Proben mit UV-Licht (5 J/cm2) vollständig geblichen. Jede Folie wurde in 6 verschiedene 10mm Breite Streifen zugeschnitten. Die Haftkräfte zwischen Photopolymer und Polycarbonat Folie erfolgte in Anlehnung an ISO/IEC 10373 mit einer Zugprüfmaschine gemäß DIN EN ISO 527-1. Details der Experimente und die Ergebnisse sind in Tabelle 7 zusammengefasst.

**Tabelle 7: Haftkräfte (in N/lOmm) gemessen zwischen Photopolymerschicht B und auflaminierte PC Folie (Substratschicht C)**

| **Beispiele** | **Schreibdosis (mJ/cm²)** | **Haftkraft [N/10mm]** | **Haftung 0 (sehr stark) bis *5 (sehr gering)*** |
|---|---|---|---|
| 20 | 29,6 | 3,5 | 3 |
| 21 | 177,8 | 3,5 | 3 |

## Patentansprüche

1. Verfahren zur Herstellung eines zumindest teilweise verbundenen Schichtaufbaus umfassend eine Photopolymerschicht B, enthaltend ein Hologramm, und eine Substratschicht C aus (Co)Polycarbonat, **dadurch gekennzeichnet, dass** das Verfahren die folgenden Schritte umfasst:
a) Direktes Inkontaktbringen einer unbelichteten Photopolymerschicht B oder einer teilbelichteten Photopolymerschicht B, enthaltend ein Hologramm, mit der Substratschicht C, sodass ein Schichtverbund B-C entsteht,
b) Erwärmen des Schichtverbundes B-C auf eine Temperatur von 70° C bis 110° C,
c) Ggf. Einbelichten eines Hologramms in die unbelichtete Photopolymerschicht B, enthaltend Matrixpolymere, Schreibmonomere, Photoinitiatoren, gegebenenfalls mindestens eine nicht photopolymerisierbare Komponente und gegebenenfalls Katalysatoren, Radikalstabilisatoren, Lösungsmittel, Additive sowie andere Hilfs- und/oder Zusatzstoffe,
d) Beaufschlagen des teilbelichteten Schichtverbunds B-C, enthaltend ein Hologramm, mit aktinischer Strahlung, vorzugsweise enthaltend UV-Strahlung,
wobei Schritt d) immer als letzter Schritt durchgeführt wird.

2. Verfahren nach Anspruch 1, **dadurch gekennzeichnet, dass** die Verfahrensschritte a)-d) in der Reihenfolge a), b), c) und d) oder in der Reihenfolge a), c), b) und d) oder in der Reihenfolge c), a), b) und d) durchgeführt werden, bevorzugt in der Reihenfolge c), a), b) und d) durchgeführt werden.

3. Verfahren nach einem der vorhergehenden Ansprüche, **dadurch gekennzeichnet, dass** der Schichtverbund B-C in Schritt b) für 0,2 Sekunden bis 60 Minuten, vorzugsweise für 0,5 Sekunden bis 30 Minuten erwärmt wird.

4. Verfahren nach einem der vorhergehenden Ansprüche, **dadurch gekennzeichnet, dass** der Schichtverbund nach Schritt b) eine Haftkraft in Anlehnung an ISO/IEC 10373 unter Verwendung einer Zugprüfmachinene nach DIN EN ISO 527-1 zwischen der Photopolymerschicht B und der Substratschicht C von mindestens 0,5 N/lOmm, vorzugsweise von mindestens 0,8 N/lOmm, bevorzugter von mindestens 0,9 N/lOmm, noch bevorzugter von mindestens 1,2 N/lOmm aufweist.

5. Verfahren nach einem der vorhergehenden Ansprüche, **dadurch gekennzeichnet, dass** die Temperatur in Schritt b) 75° C bis 110° C, vorzugsweise 80° C bis 110° C, noch bevorzugter 90° C bis 110° C beträgt.

6. Verfahren nach einem der vorhergehenden Ansprüche, **dadurch gekennzeichnet, dass** Schritt b) in einem beheizten Raum, vorzugsweise einem Ofen, oder durch einem Laminator durchgeführt wird.

7. Verfahren nach einem der vorhergehenden Ansprüche, **dadurch gekennzeichnet, dass** Schritt a) und Schritt b) in einem gemeinsamen Schritt durchgeführt werden.

8. Verfahren nach einem der vorhergehenden Ansprüche, **dadurch gekennzeichnet, dass** die Photopolymerschicht B auf einer Substratschicht A vorliegt, wobei die Schichten A und B klebstofffrei miteinander verbunden sind, wobei die Substratschicht A vorzugsweise eine transparente thermoplastische Substratschicht oder Glas ist

9. Verfahren nach einem der vorhergehenden Ansprüche, **dadurch gekennzeichnet, dass** die Substratschicht C auf einer Substratschicht D vorliegt und mit dieser zumindest teilweise verbunden ist, vorzugsweise klebstofffrei verbunden ist, wobei die Substratschicht D vorzugsweise aus einem transparenten thermoplastischen Material oder einem Materialverbund besteht.

10. Verfahren nach einem der vorhergehenden Ansprüche, **dadurch gekennzeichnet, dass** die Glasübergangstemperatur T_{g} der Substratschicht C höher ist als die Temperatur in den Verfahrenschritten a)-d) zur Herstellung des Schichtverbundes B-C.

11. Verfahren nach einem der vorhergehenden Ansprüche, **dadurch gekennzeichnet, dass** die Substratschicht C eine aromatische Polycarbonatschicht, vorzugsweise eine aromatische Homopolycarbonatschicht ist.

12. Schichtaufbau umfassend eine Photopolymerschicht B, enthaltend ein Hologramm, und eine Substratschicht C aus (Co)Polycarbonat erhältlich oder erhalten nach dem Verfahren der Ansprüche 1 bis 11.

13. Versiegeltes holographisches Medium enthaltend einen Schichtaufbau nach Anspruch 12.

14. Optische Anzeige, umfassend ein versiegeltes holographisches Medium nach Anspruch 13, wobei die optische Anzeige vorzugsweise ausgewählt sind aus der Gruppe bestehend aus autostereoskopische und/oder holographische Displays, Projektionsleinwände, Projektionsscheiben, Displays mit schaltbaren eingeschränkten Abstrahlverhalten für Privacyfilter und bidirektionalen Multiuserbildschirmen, virtuelle Bildschirme, Headup-Displays, Head-mounted Displays, Leuchtsymbole, Warnlampen, Signallampen, Scheinwerfer und Schautafeln.

15. Sicherheitsdokument, umfassend ein versiegeltes holographisches Medium nach Anspruch 14 oder einen Schichtaufbau erhältlich aus dem Verfahren gemäß einem der Ansprüche 1-11.
